(19) Europäisches Patentamt

European Patent Office

Office européen des brevets

(11) **EP 0 616 384 B1**

(12) **EUROPEAN PATENT SPECIFICATION**

(45) Date of publication and mention
of the grant of the patent:
**31.05.2000 Bulletin 2000/22**

(51) Int. Cl.$^7$: **H01Q 1/27**

(21) Application number: **94301911.7**

(22) Date of filing: **17.03.1994**

(54) **Antenna device and apparatus including such an antenna device**

Antenne und diese enthaltendes Gerät

Antenne et dispositif incluant une telle antenne

(84) Designated Contracting States:
**CH DE FR GB LI**

(30) Priority: **17.03.1993 JP 5742893**
        **17.03.1993 JP 5743293**
        **29.03.1993 JP 7038493**

(43) Date of publication of application:
**21.09.1994 Bulletin 1994/38**

(73) Proprietor:
**SEIKO EPSON CORPORATION**
**Shinjuku-ku, Tokyo 163-0811 (JP)**

(72) Inventor:
**Hama, Norio,**
**c/o Seiko Epson Corp.**
**Suwa-shi, Nagano-ken 392 (JP)**

(74) Representative:
**Sturt, Clifford Mark et al**
**Miller Sturt Kenyon**
**9 John Street**
**London WC1N 2ES (GB)**

(56) References cited:
**EP-A- 0 538 485          EP-A- 0 565 725**
**GB-A- 2 201 266          US-A- 5 007 105**

• **PATENT ABSTRACTS OF JAPAN vol. 6, no. 55
(E-101) (933) 10 April 1982 & JP-A-56 169 401
(SHIYUUICHI SAKAI) 26 December 1981**

**Description**

The present invention relates to antenna devices and apparatus including such antenna devices.

Conventionally, small-size portable apparatus, such as TV, a radio receiver, radio transmitter or mobile telephone, including an antenna device, includes an antenna of the loop type. The electrical operational theory and structure of this type antenna is, for example, is disclosed in the article entitled "A loop antenna for a small-sized portable radio set" published in "National Technical Report Vol. 19, No. 2, Apr. 1973". It is also known to provide a loop antenna at its central portion in the longitudinal direction with a reactance element. In addition, where the radio frequency is relatively high, an inverted F antenna is sometimes used for a radio set.

A small size portable radio set capable of being mounted on a user's wrist, like a watch, has been developed. Typical examples of such wrist-mounted portable radio sets are disclosed in US-A-4,713,808, wherein a loop antenna is provided, and in Japanese Patent Laid-Open No. HEI 4-211522, wherein a short dipole antenna is provided.

However, where a loop antenna or dipole antenna is used in a wrist-mounted portable radio set, the sensitive directivity of the antenna is degraded, and the satisfactory properties of the antenna cannot be expected, because the antenna is set in a state contacting the user's wrist when the radio set is mounted.

EP-A-0565725 proposes to use a slot antenna for wrist-mounted portable radio sets and the like, comprising a wrist-mountable electronic device, with a main body having a circuit board therein, and a slot antenna connected to the circuit board, the slot antenna including antenna elements located in wrist straps attached to the main body and electrically conductive members connecting the antenna elements and located within the main body. Further improvements are desirable in controlling and improving antenna gain and directivity.

The present invention provides a wrist-mountable electronic device, comprising a main body having a front surface facing away from a wearer in use, and a rear surface facing towards the wearer in use, and a circuit board therein, and an antenna device comprising a slot antenna connected to the circuit board, the slot antenna including antenna elements located in wrist straps attached to the main body, and electrically conductive members connecting the antenna elements and located within the main body, characterised in that the electrically conductive members are spaced from and on the side of the circuit board closer to the front surface of the main body; and in that the main body contains a reflective plate to enhance the antenna gain effect, the reflective plate being located in the main body on the side of the circuit board closer to the rear surface of the main body.

The inductance value of the antenna is defined by the circumferential length of the slot and width of the electrically conductive plate of the antenna irrespective of the length of the wrist straps when mounted around the user's wrist. Therefore, it is advantageous because a high antenna gain can be maintained even if the size of the user's wrist varies. In addition, when mounted around the user's wrist, the slot antenna is arranged so that the slot thereof faces outwardly, and therefore it is advantageous because the slot antenna is capable of detecting magnetic field contents generated around the body surface or wrist of the user.

In order to increase the sensitivity of the radio set, the slot antenna may be assembled in a special manner. The reasons are as follows:

First, in the wrist-mounted portable radio set having the slot antenna, the radio receiving portion thereof is electrically connected to the slot antenna. The connecting points define the feed point of the antenna, which is inevitably located about the central portion of the slot antenna in the longitudinal direction thereof. As a result, this feed point is situated in the main body of the radio set having a variety of circuit components accommodated therein. An area around the central portion where the feed point is located is the portion where the radiated energy of the electrical waves is a maximum. However, around the feed point, there are arranged in a restricted space in the main body of the radio set a variety of components incorporating materials having an insulating or dielectric effect, attenuation effects, conduction effects and so on. If the attenuation or electrically conductive components are arranged along the radial direction of the electrical waves, the radiated energy may be attenuated or degraded thereby, which causes a decrease in the sensitivity of the slot antenna.

Second, in the restricted thin space of the main body of the radio set, circuit components which generate noise signals adversely affecting the transmitting and receiving sensitivities of the radio set must be arranged around the central portion of the slot antenna accommodated in the main body. Those circuit components include digital-signal processing circuits, voltage booster circuits, DC/DC converters and the like. The noise signals become transmission noises and radiation noises, which cause a decrease in the sensitivity of the radio set. Especially, where a certain type of circuit system is adopted, the radiation noises may cause disturbance not only of the radio set output, but also of other radio sets.

Third, as the slot antenna is provided at its central portion in the longitudinal direction with a reactance element connected in order to resonate at a specific frequency, the portion of the slot antenna located in the main body of the radio set has a high impedance state. Thus, the value of Q of the antenna circuitry increases, so that the antenna impedance may be altered by the human body when the radio set is mounted. As a result, the most appropriate matching condition between the radio receiving section and the antenna section may not be achieved, whereby the transmitting and receiving sensitivity is decreased. While it is possible to lower the value of Q by arranging an additional electrical element in the circuitry of the radio set, this is not recommendable because it prevents reduction of the size of the wrist-mounted portable radio set.

Fourth, in a wrist-mounted portable radio set, if the slot antenna is partially mounted in the wrist straps, it must be increased in strength. This means that an increase in electrical resistance loss of the slot antenna must be accepted.

When a display unit is located on the front surface of the main body, the antenna assembly can be arranged to expose the display unit, or the antenna assembly may be made from a substantially transparent thin conductive film. If the main body has an outer frame, the antenna assembly may be disposed on it, so that the slot extends around a preipheral surface.

In order to prevent or reduce noise in a high sensitivity radio set, the wrist-mounted antenna device has one member connected to a reference voltage side of a high frequency wave amplifier, and another member connected to a signal voltage side of the high frequency wave amplifier. One member having a low impedance is disposed near noise sources contained in the circuitry carried by the circuit board, and the other member having a high impedance is disposed further from the noise sources.

In addition, the wrist-mounted antenna device is so arranged as to have an optimum electric power feeding point to the antenna assembly in order to achieve high sensitivity. The wrist-mounted antenna device may comprise antenna portions having different lengths with respect to the main body. This enables the power feeding point to be moved from the connection point of reactance element located almost centrally of the antenna assembly. The reactance element can be arranged in a wrist strap using overlapping portions of the antenna part installed in that wrist strap.

Where the antenna assembly can be spaced from the human body, the effect of the human body can be reduced. Therefore, the wrist straps may be thickened or have projections or the like on the rear surface side, especially near the high impedance part of the antenna.

The wrist-mounted antenna device may have a means for reducing the loss of resistivity at the distal end of the antenna assembly to upgrade the sensitivity. The wrist-mounted antenna device may have a high dielectric material layer on the surface of the antenna assembly to catch a longer wave length radiation wave without extending the antenna assembly.

The scope of the invention is defined by the appended claims; and how it can be carried into effect is hereinafter particularly described, with reference to the accompanying drawings, in which:-

Figure 1(a) is a diagrammatic perspective view of a first embodiment of wrist-mounted portable radio set according to the present invention;
Figure 1(b) is a diagrammatic view of an antenna assembly in the radio set of figure 1(a);
Figure 2 illustrates diagrammatically the arrangement of a slot antenna in the main body of the radio set of figure 1;
Figure 3 is a diagrammatic cross-sectional view of the main body of the radio set of figure 1;
Figure 4(a) illustrates general directivity of a slot antenna;
Figure 4(b) illustrates the directivity of a slot antenna of the radio set of figure 1;
Figure 5 is a schematic block diagram of circuitry for driving the radio set of figure 1;
Figure 6(a) is a schematic block diagram of circuitry of a typical single super-heterodyne radio;
Figure 6(b) illustrates a schematic block diagram of circuitry of a typical direct-conversion radio;
Figure 7 illustrates directivity of a wrist-mounted radio set having a slot antenna;
Figure 8 illustrates directivity of an antenna of the radio set of figure 1;
Figure 9 is a schematic cross-sectional view of part of a second embodiment of portable radio set according to the present invention;
Figure 10 illustrates the arrangement of a slot antenna in the main body of the radio set of figure 9;
Figure 11(a) illustrates an alternative arrangement of slot antenna in the main body of the radio set of figure 9;
Figure 11(b) illustrates another alternative arrangement of slot antenna in the main body of the radio set of figure 9;
Figure 12 is a partial plan view of a third embodiment of portable radio set according to the present invention;
Figure 13 is a partial plan view of a fourth embodiment of portable radio set according to the present invention;
Figure 14(a) is a partial plan view of a fifth embodiment of portable radio set according to the present invention;
Figure 14(b) is a partial side view of the radio set of figure 14(a);
Figure 15 is a perspective view of a sixth embodiment of a wrist-mounted portable radio set according to the present invention;
Figure 16 is a schematic sectional view taken along line X-Y of figure 15;
Figure 17 is a schematic sectional view taken along line Z-U of figure 15;
Figure 18 illustrates the circuitry layout on the upper surface of a circuit board assembly of the radio set of figure 15;

Figure 19 illustrates the circuitry layout on the lower surface of the circuit board assembly of the radio set of figure 15;

Figure 20 is a diagrammatic plan view partly in section of the radio set of Figure 15;

Figure 21 is a diagrammatic cross section of the main body of the radio set of Figure 15;

Figure 22(a) illustrates the layout of portions of a seventh embodiment of portable radio set according to the present invention;

Figure 22(b) illustrates the layout of portions of an eighth embodiment of portable radio set according to the present invention;

Figure 23 is a graph of noise level against frequency showing the reduction of noise level achieved by the sixth to eighth embodiments of radio set;

Figure 24 is a partial schematic cross-sectional view of a ninth embodiment of portable radio set according to the present invention;

Figure 25 is a perspective view of a tenth embodiment of portable radio set according to the present invention;

Figure 26 is a diagram of the slot antenna to assist explanation of the distribution of electrical current and voltage in the antenna of figure 25;

Figure 27 is a graph showing a relationship between the position of the feed point and impedance characteristic in the radio set of figure 25;

Figure 28(a) is a perspective view of an eleventh embodiment of portable radio set according to the present invention;

Figure 28(b) illustrates the arrangement of holes in a wrist strap and the shape of the antenna in the radio set of figure 28(a);

Figure 29 is a diagrammatic sectional view of a capacitor formed on the antenna of figure 28(a);

Figure 30 is a perspective diagrammatic view of the capacitor of figure 29;

Figure 31 is a perspective view of the antenna of a twelfth embodiment of portable radio set according to the present invention;

Figure 32 is a perspective view of an alternative antenna for the twelfth embodiment of radio set;

Figure 33 is partial plan view of an antenna arranged in a wrist strap in a thirteenth embodiment of wrist-mounted portable radio set according to the present invention;

Figure 34 is a sectional view of the antenna of figure 33;

Figure 35 is a partial plan view of an antenna arranged in a wrist strap in a fourteenth embodiment of portable radio set according to the present invention;

Figure 36 is a sectional view of an end of an antenna arranged in a wrist strap in a fifteenth embodiment of portable radio set according to the present invention;

Figure 37 is a perspective view of a wrist strap of a sixteenth embodiment of portable radio set according to the present invention;

Figure 38 is a partial longitudinal sectional view of the wrist strap of figure 37;

Figure 39 is a perspective view of a wrist strap of a seventeenth embodiment of portable radio set according to the present invention;

Figure 40 is a partial longitudinal sectional view of the wrist strap of figure 39;

Figure 41 illustrates an eighteenth embodiment of wrist-mounted portable radio set according to the present invention, wherein a main body of the radio set is disconnectible from a pair of wrist straps; and

Figure 42 is an exploded sectional view of the radio set of figure 41.

Reference is also made to the article entitled "A Study on Small Slot Antenna for Wrist Watch Type Portable Radio Equipment" published in The Institute of Electronics Information and Communication Engineers published on 17th August 1993.

First Embodiment

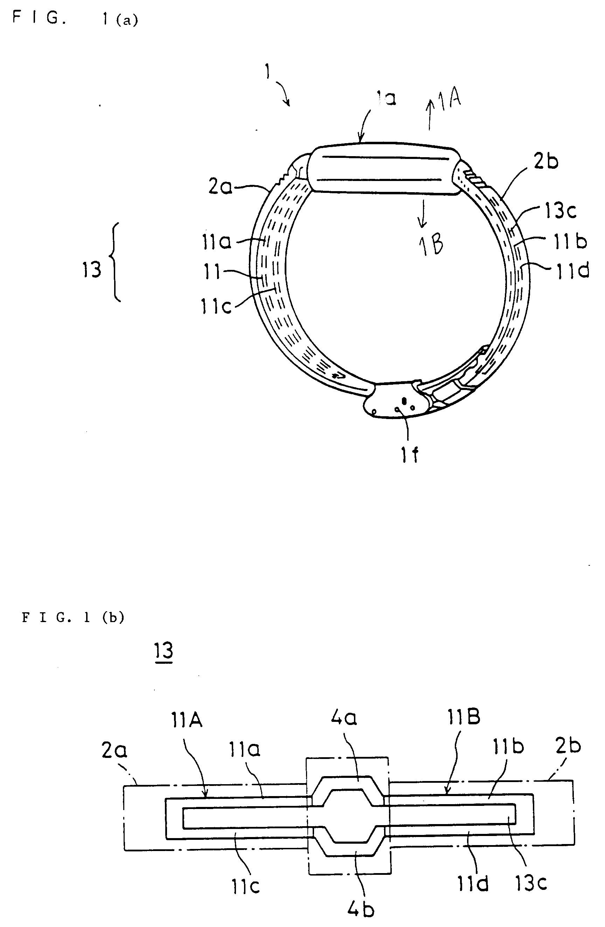

A wrist-mounted portable radio set (figure 1(a)) has a main body 1a, a pair of wrist straps 2a, 2b connected to either side of the main body la, and an antenna assembly 13 arranged in the main body 1a and the wrist straps 2a and 2b. The wrist straps 2a and 2b are releasably connected to each other at their distal ends by means of a clasp 1f.

The antenna assembly 13 (figure 1(b)) is composed of an antenna part 11A mounted in the wrist strap 2a, an antenna part 11B mounted in the other wrist strap 2b, and a pair of electrically conductive plates 4a, 4b arranged in the main body 1a to connect electrically the antenna parts 11A and 11B. The part 11A comprises antenna elements 11a and 11c which are electrically connected at their distal ends, and the antenna part 11B comprises antenna elements 11b and 11d which are also electrically connected at their distal ends, so that a slot 13c is defined by the elements comprising the antenna assembly 13. Although the wrist straps 1a and 2b (figure 1(a)) are connected by the clasp 1f, the antenna plates 11A and 11B are not necessarily electrically connected at their distals ends, although they can be.

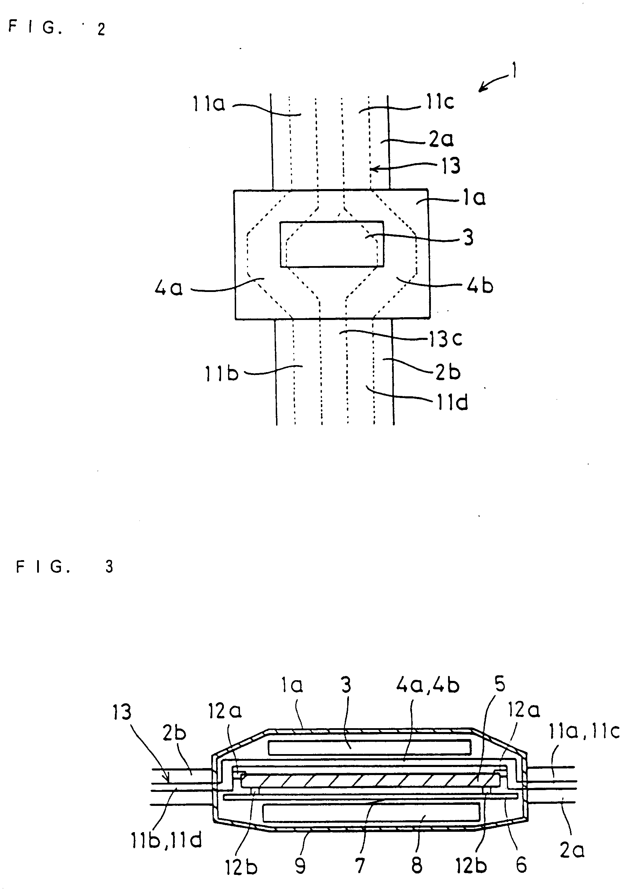

The main body 1a of the radio set 1 has a front surface 1A and a rear surface 1B. When the radio set 1 is mounted around the user's wrist, the rear surface 1B is positioned facing the user's wrist, while the front surface 1A is positioned to face away from the user's wrist, such as the liquid crystal display (LCD) 3 (figure 2). The main body 1a of the radio set 1 has a data display unit and the electrically conductive plates 4a, 4b, are arranged on either side of the front surface 1A thereof.

In the main body 1a of the portable radio set 1 (figure 3) starting from the front face thereof are the display unit 3, the electrically conductive plates 4a, 4b, a circuit board 5, an electrically-conductive reflective plate 6, a battery 8 and a rear case 9. The circuit board 5 has circuitry mounted thereon and wire pattern for a high frequency ground (not shown) formed thereon. Where a multi-layer circuit board is used, the wire pattern for the high frequency ground is formed in an inner-layer. The reflective plate 6 is connected to one of poles of the battery 8 via a terminal plate 7 so that the high frequency ground at the rear side of the electrically conductive plates 4a, 4b is maintained at an appropriate level. The battery 8 can be replaced easily by a new one by removing the rear case 9. The rear case 9 is electrically connected to the other pole of the battery 8 and also electrically connected to the circuit board 5 via a terminal plate (not shown). The circuit board 5 is electrically connected to the reflective plate 6 by means of a pair of connectors 12b.

In the first embodiment, the circuit board 5 is arranged on the rear side of the electrically conductive plates 4a and 4b of the antenna assembly 13, and is connected electrically thereto by a pair of terminal plates 12a. These connecting portions define a feed point to the antenna assembly 13, or a connecting point for a reactance element. Therefore, in the antenna assembly 13, portions of the antenna plates 11a, 11b (or 11c, 11d) adjacent to the feed point and the electrically conductive plate 4a (or 4b) are those which exhibit high frequency impedance and radiate electric waves of the strongest magnitude compared to the other portions of the antenna assembly 13.

In the portable radio set 1, radio waves are transmitted and received through the front surface 1A on which the display unit 3 is mounted. Therefore the antenna assembly 13 is constituted to have the directivity on its front surface 1A side so as to reduce the loss.

The circuit board 5 and the reflective plate 6 both have the high frequency ground and are arranged on the rear side of the electrically conductive plates 4a and 4b to exert their reflective ability and focus the directivity towards the front surface 1A. In addition, when the portable radio set 1 is mounted on the user's wrist, the wrist contacts the rear case 9 thereof, but the antenna assembly 13 is shielded by the rear case 9 and the reflective plate 6 against the effect of the user's wrist. Therefore, the antenna assembly 13 is not affected by the human body, so that its impedance does not change and its sensitivity is high.

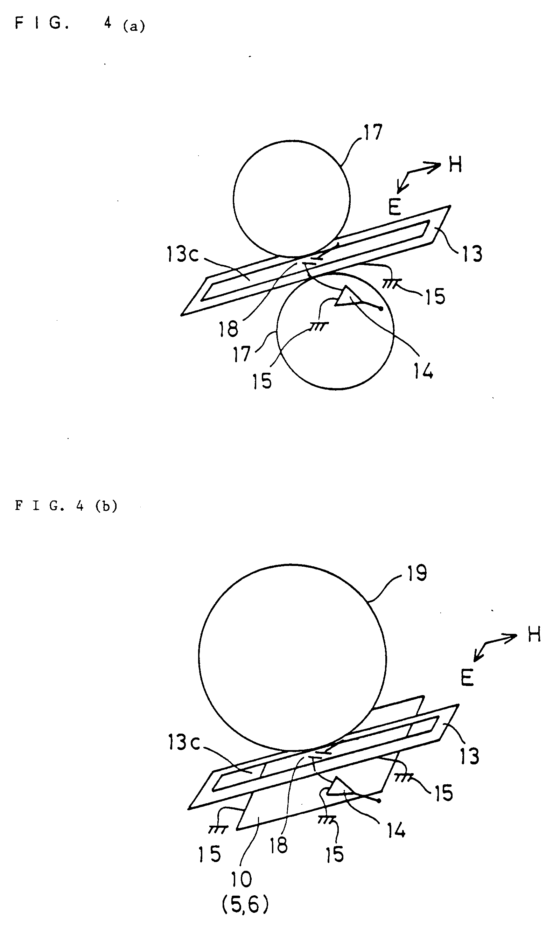

In explanation of this, consider figures 4(a) and 4(b).

In figures 4(a) and 4(b), the antenna assembly 13 has the slot 13c disposed along the central line thereof, and a capacitor 18 acts as a reactance element arranged at the centre of longer side thereof and is connected across the slot 13c. If the capacitor 18 has an appropriate capacitance, the antenna assembly 13 operates as a slot antenna. The capacitor 18 is mounted on the circuit board 5.

In figure 4(a), an arrow H shows the magnetic field of polarisation surface of radiated waves from the slot antenna, and an arrow E shows an electrical field thereof. In figure 4(a), a property of the radiation patterns of the slot antenna are shown using two solid lines 17 which have perpendicular components against the slot 13c with tendencies acting in opposite directions. A radiation centre of the waves from the slot antenna is located on the central portion of the slot 13c. As is known well in this art, a property of radiation of a dipole antenna is the same if the direction of the magnetic field and the direction of the electrical field of the slot antenna are changed in relation to each other.

However the present antenna assembly 13 is a magnetic field affecting antenna, in addition to being a slot antenna. Therefore, if a ground plate 10 is mounted parallel to the centre of the antenna 13, the property of radiation of the antenna 13 is better, as shown in figure 4(b) by the single solid line 19, and the gain of antenna 13 becomes high. In the portable radio set 1, as the circuit board 5 and the reflective plate 6 are arranged on the rear surface side of the antenna assembly 13 especially of the electrically conductive plates 4a and 4b, if the board 5 and plate 6 are used as the ground plate 10, the radiation wave from the antenna 13 to the front surface is not blocked by them. As the ground plate 10 composed of the circuit board 5 and the reflective plate 6 has an image effect and acts as a reflector facing to the front surface, the directivity of the antenna assembly 13 in figure 4(b) is about twice that of the antenna of figure 4(a). In addition, where the portable radio set is mounted on the user's wrist, the wrist is located under the circuit board 5 and the reflective plate 6. Therefore, the user's wrist can be used as a part of the ground plate 10 and the magnetic field around the human body can be used actively.

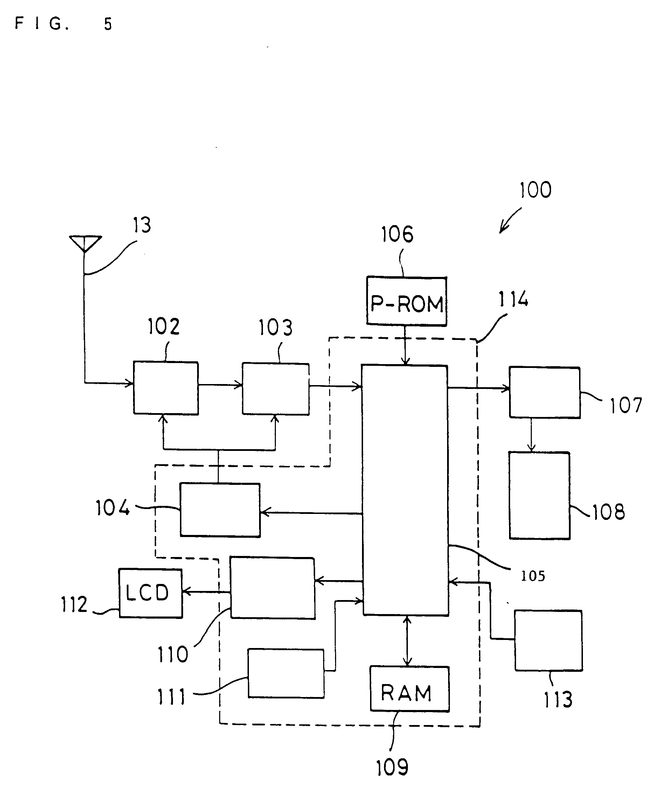

One of the terminals of the capacitor 18 is connected to a high frequency amplifier circuit 14 and the other terminal thereof is connected to ground 15. The high frequency amplifier circuit 14 is included in a radio transmitter portion and/or receive portion 102 (figure 5) of a circuit 100. The circuit portion 102 is connected to the antenna assembly 13 and its output is to a wave shaping circuit 103. A power control circuit 104 supplies electric power to the circuits 102 and 103, and a control circuit 105 controls, *inter alia,* the power control circuit 104. The circuit 100 also includes a programmable read only memory (P-ROM) 106 for storing an assigned call number to be provided to the control circuit 105, a random access memory (RAM) 109 for storing received information allocated to the assigned call number, a liquid crystal display (LCD) 112 of the data display unit 3 for displaying information, an LCD driving circuit 110 for controlling the LCD 112, and oscillator circuit 111 for supplying a clock signal to control the LCD driving circuit 110. A message processing portion 114 is constituted by the power control circuit 104, the control circuit 105, the RAM 109, the LCD driving circuit 110 and the oscillator circuit 111. The LCD 112 displays the message processed in the message processing portion 114. The circuit 100 also has an alarm unit 108 and an alarm generating circuit 107 for announcing that a message is in memory. The alarm unit 108 may be a buzzer, LED, vibrator or the like. The circuit 100 also includes an outer switching operation portion 113.

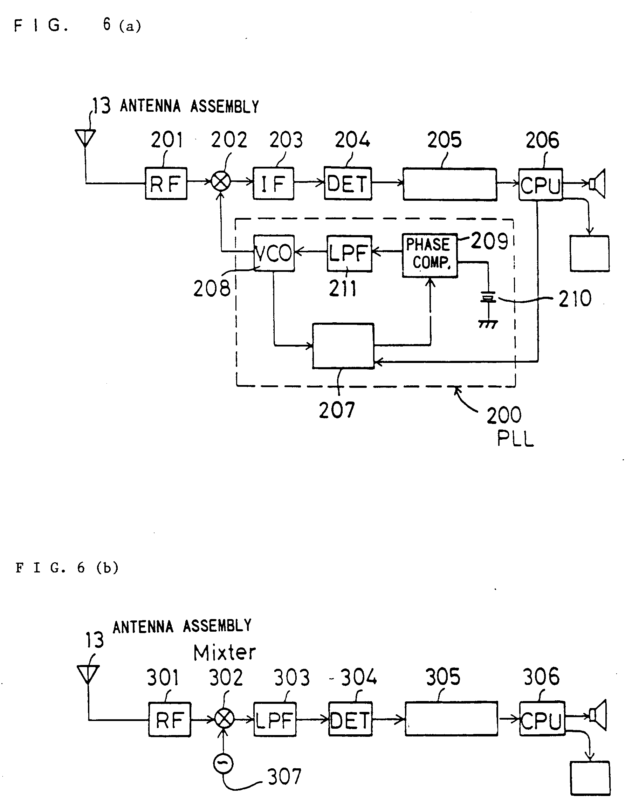

Where the radio set is of the single super heterodyne type (figure 6a)), the circuit portion 102 has an RF amplifier 201 (the high frequency wave amplifier 14), a mixer 202, and an IF amplifier 203 connected sequentially from the antenna assembly 13. The amplifier 203 feeds a detector 204 (the wave shape circuit 103) and a decoder 205 and CPU 206 from the control circuit 105. In the circuit portion 102, according to a demultiplier rate signal generated from the CPU 206, a pre-scalar 207 in a PLL 200 corresponding to a desired frequency, the pre-scalar 207 demultiplies a current frequency in VCO 208. The VCO 208 outputs, for example, 51 kHz square wave signal to a phase comparator 209. A reference oscillator 210 connected thereto oscillates constantly to generate, for example, 50 kHz. As there is 1 kHz deviation between the 51 kHz square wave signal and the reference oscillator 210, the phase comparator 209 generates a square wave signal having a pulse width corresponding to the deviation. A low pass filter 211 connected to the phase comparator 209 converts the signal to a new voltage signal having almost direct current component. The direct current signal is supplied to the VCO 208 to vary the desired frequency supplied to the mixer 202. In the single super heterodyne method, the antenna-received high frequency wave signal is mixed with the oscillator output in the mixer 202, and is converted into an intermediate frequency signal corresponding to the deviation thereof and is then regenerated as a received signal. The intermediate frequency signal generally has a frequency of 455 kHz. The reference oscillator can generate the signal having a frequency, for example, of 2 to 3 MHz.

Where the radio set uses the direct conversion method (figure 6(b)), the circuit portion 102 has an RF amplifier 301 (the high frequency wave amplifier 14), a mixer 302, a low pass filter 303, a detector 304, a decoder 305, and a CPU 306 and these are connected sequentially from the antenna assembly 13. In the direct conversion method, in contrast to the superheterodyne method, a received signal is not converted to the intermediate frequency (IF) signal. Effectively, the intermediate frequency (IF) becomes 0 Hz. The low pass filter 303 passes the signal having a base band frequency of 0 to 10 kHz. In the direct conversion method, the circuit frequency is same as the oscillator frequency of the local oscillator 307, and under such conditions a signal. having the base band frequency passes.

A transmitted signal having a circuit frequency is demodulated at the circuit portion 102 (figure 5) via the antenna assembly 13, then converted into square wave in the wave shape circuit 103. The control circuit 105 and power control circuit 104 supply electrical power to the wave shape circuit 103 and the circuit portion 102 only during the time when they receive signals. The control circuit 105 generates a battery-saving timing signal to supervise the power supply and to control the power control circuit 104. The control circuit 105 also performs a bit synchronisation and a frame synchronisation using received signal. In addition, in the control circuit 105, the assigned call number stored in the P-ROM 106 is compared with the received signal supplied from the wave shaping circuit 103 with error correction so as to judge whether the assigned call number is called or not. The control circuit 105 also has a counting function to generate a signal using the oscillator circuit 111 which uses a reference signal source such as quartz crystal.

After the call is confirmed, message data is received followed by the assigned call number and is stored in the RAM 109. The alarm device 108 announces to a user called under the control of the alarm driving circuit 107. According to a control in the outer operating portion 113 consisting of switch or the like, the message stored in the RAM 109 is supplied to the LCD driving circuit 110 via the control circuit 105. The LCD driving circuit 110 displays the message on the LCD 112 using the clock signal supplied by the oscillator circuit 111.

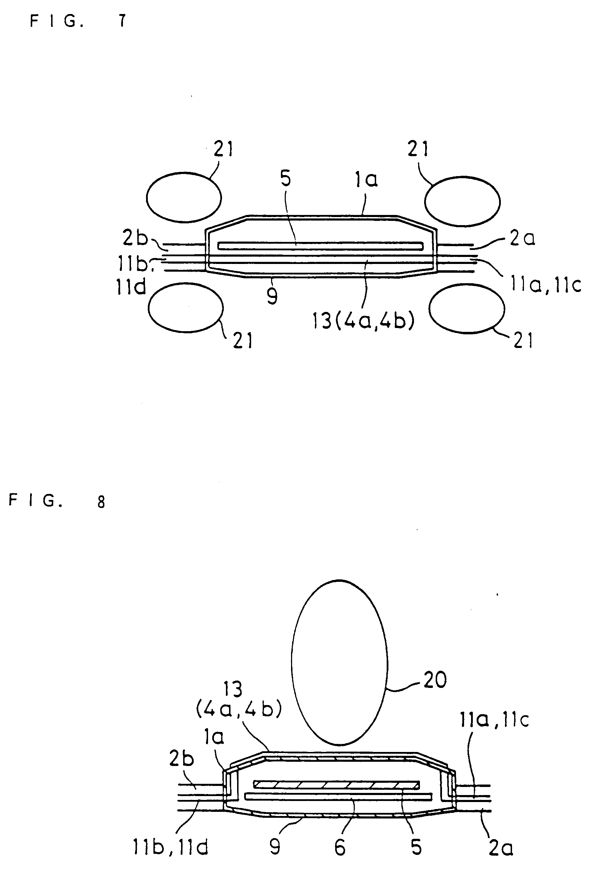

In a wrist-mounted portable radio set, the antenna assembly has a power supply point at its centre, so that a part having the maximum radiation wave energy is located in the main body. If components of insulating material, dielectric material, attenuation material, electrical conductive material such as the circuit board 5 are contained in the main body 1a and the circuit boards (figure 7) is disposed on the wave radiating direction side of the antenna assembly 13, the radiation pattern is divided into four, as shown by four solid lines 21, and its sensitivity is reduced.

In the present portable radio set (figure 8) the circuit boards is disposed on the rear side of the antenna assembly 13 so as not to block the wave radiation therefrom. Therefore, the radiation energy of the wave is neither shielded nor lost. The circuit board 5 and the reflective plate 6 disposed on the rear side of the antenna assembly have an image effect to upgrade the directivity. Accordingly, the radiation pattern of the present portable radio set has high directivity towards the front surface side of the main body 1a as shown in figure 8. The circuit board 5 and the reflective plate 6 disposed on the rear side of the antenna assembly can shield the effect of the human body so that the impedance matching between the radio transmit/receive portion and the antenna portion does not charge.

## Second Embodiment

In the first embodiment, in order to locate the circuit board 5 on the rear side of the electrically conductive plates 4a and 4b, these plates 4a and 4b were disposed between the circuit boards and the display unit 3.

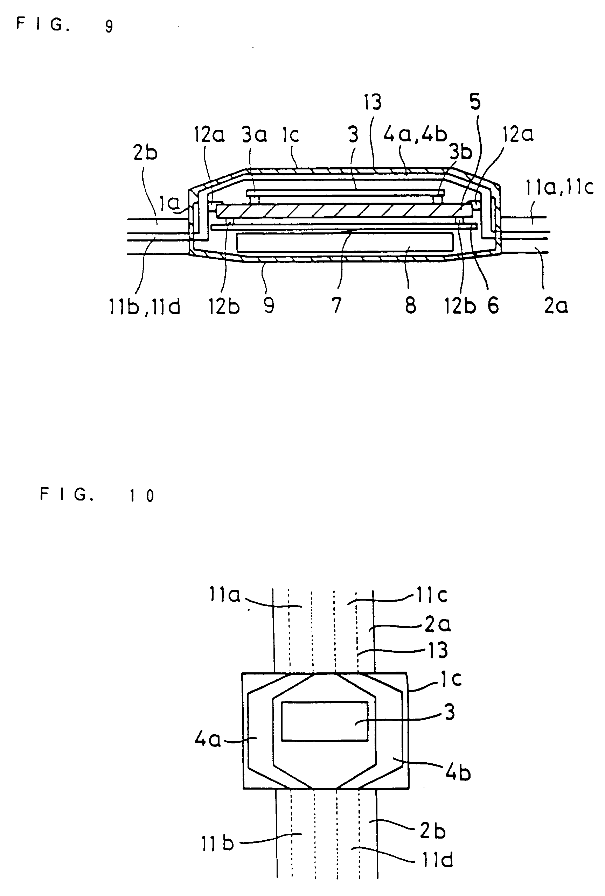

In the second embodiment (figure 9) the electrically conductive plates 4a and 4b are disposed on the front side of the data display unit 3 so that these plates 4a and 4b are on the rear side of the front case 1c of the main body 1a.

In order to keep an open area over the data display units (figure 10), the electrically conductive plates 4a and 4b are arranged generally along the side edges the data displaying unit 3 and are disposed on either side of the display unit 3. Therefore, because the circuit board 5, reflective plate 6 and the data display unit 3 are not on the front surface side of the antenna assembly 13 there is no loss affecting the radiation wave and the radiation energy level can remain high.

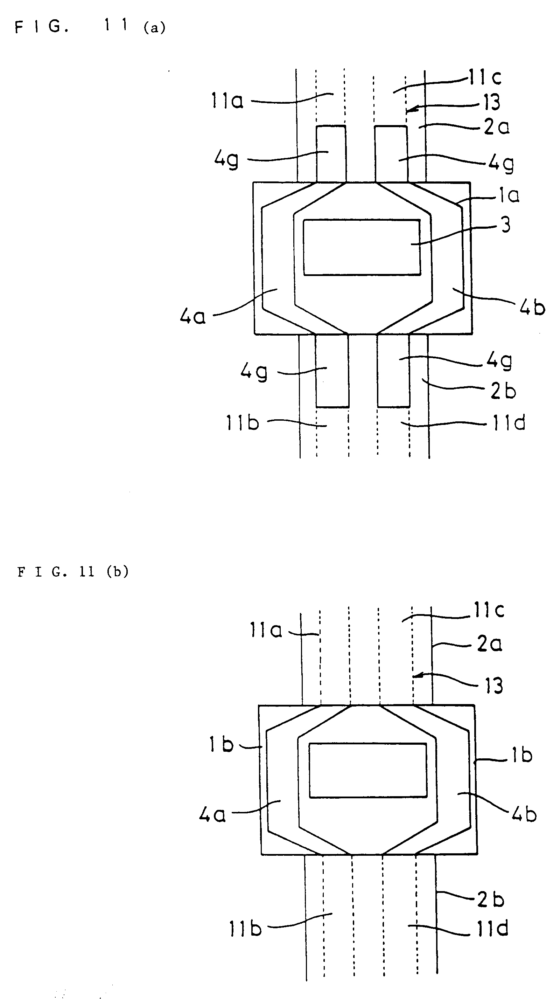

The electrically conductive plates 4a and 4b in the main body 1a can be connected to the antenna elements 11a and 11b and 11c and 11d, respectively, in the wrist straps 2a and 2b around the periphery of the main body 1a. The electrically conductive plates 4a and 4b can be integrated with the antenna elements 11a to 11d. The electrically conductive plates 4a and 4b (figure 11(a)) may have terminals 4g projecting from the main body 1a and connected to the antenna elements 11a to 11d the wrist band 2a and 2b.

Where the main body 1a has an outer frame 1b (figure 11(b)), the electrically conductive plates 4a and 4b can be formed as an integrated pattern on the inner side of the outer frame 1b.

## Third Embodiment

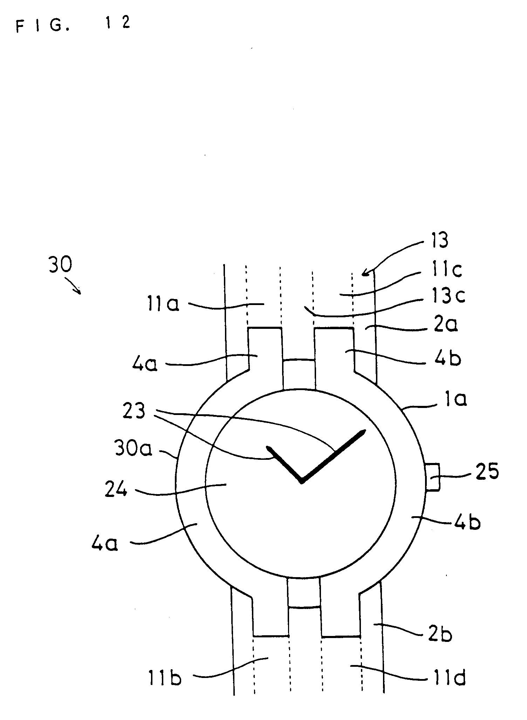

The third embodiment of wrist-mounted portable radio set 30 (figure 12) has the main body 1a containing an analog watch having minute and hour hands 23 to show time on a clock face 24, and crown wheel 25 to alter the position of the hands and to wind the clock mechanism. The electrically conductive plates 4a and 4b are disposed on the front surface side (bezel portion) of an outer frame 30a of the clock face 24. The electrically conductive plates 4a and 4b are electrically connected to respective antenna elements 11a to 11d in the wrist straps 2a and 2b. The antenna assembly 13 is constituted by the electrically conductive plates 4a, 4b, and antenna elements 11a to 11d, and has a slot 13c.

In the radio set 30, the electrically conductive plates 4a and 4b are arranged on the front surface face of the main body 1a. The clock face 24 is made of non-metallic material so that the radiation wave from the electrically conductive plates 4a and 4b is not shielded thereby. The circuit board 5 is disposed in the main body 1a on the rear face side of the clock face 24, and thus of the plates 4a and 4b. The power feeding point to the antenna assembly 13 which has the maximum radiation energy is the centre of the longer side of the assembly 13 and is located on the electrically conductive plates 4a and 4b. As the radiation from the electrically conductive plates is not shielded, the energy of the radiation wave can be kept at a high level. The circuit board 5 and the other parts arranged on the rear side of the antenna assembly 13 act as a reflector so that the directivity of the antenna assembly is upgraded. The circuit board 5 and the other parts also can shield the effect of the human body, so that the matching between the radio transmit/receive portion and the antenna assembly does not deviate.

## Fourth Embodiment

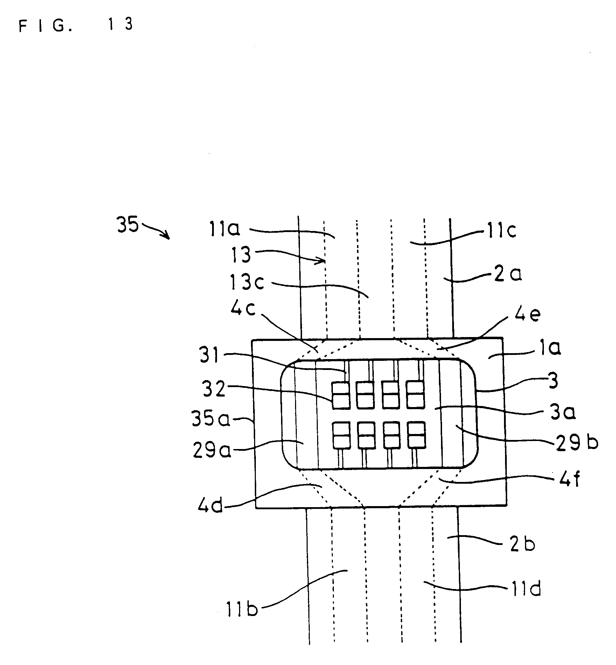

In the fourth embodiment of wrist-mounted portable radio set 35 (figure 13), the main body 1a has outer frame 35a on which electrically conductive plates 4c to 4f is prepared, and two lengths 29a and 29b of thin film conductive pattern are arranged on a display surface 3a of the data display unit 3 in order to form a part of the antenna assembly 13 in the main body 1a. The electrically conductive plates 4c and 4d and 4e and 4f are electrically connected, respectively, by the conductive patterns 29a and 29b. The antenna assembly 13 which is a slot antenna having the slot 13c, is constituted by the conductive patterns 29a and 29b, the electrically conductive plates 4c to 4f, and antenna elements 11a to 11d. On the surface 3a of the data display unit 3, in addition to the conductive patterns 29a and 29b, there are arranged segment electrodes 32 and circuit patterns 31 for applying voltage for driving thereof.

As the display surface 3a of the display unit 3 is positioned on the front surface of the main body 1a, the conductive patterns 29a and 29b are also positioned on the front surface of the main body 1a. Hence, the circuit board 5 and other components in the main body 1a are arranged on the rear side of the conductive patterns 29a and 29b. The conductive patterns 29a and 29b made of thin film is optically transparent. Therefore even if these patterns extend over a large area of the data display unit 3, the function of that unit data indication is not limited.

In the portable radio set 35, the electrical feeding point to the antenna assembly 13 is located on the conductive patterns 29a and 29b and is arranged at a centre portion of the antenna assembly 13, because the portion having maximum radiation energy of wave is disposed on the front surface of the main body 1a. In the present portable radio set 35, the radiation energy can be kept at a high level. In addition, the image effect of the circuit board 5 disposed at the rear side of the antenna assembly 13 upgrades its directivity. The effect of the human body can be shielded as in the first embodiment, so that the impedance matching between the radio transmit/receive portion and antenna assembly of the portable radio set does not deviate when it is mounted on a user's wrist.

The conductive patterns 29a and 20b can be arranged on the top layer of a multi layer circuit pattern disposed on the data displaying unit 3. The conductive patterns 29a and 29b could alternatively be arranged as a middle layer or lower layer thereof.

Fifth Embodiment

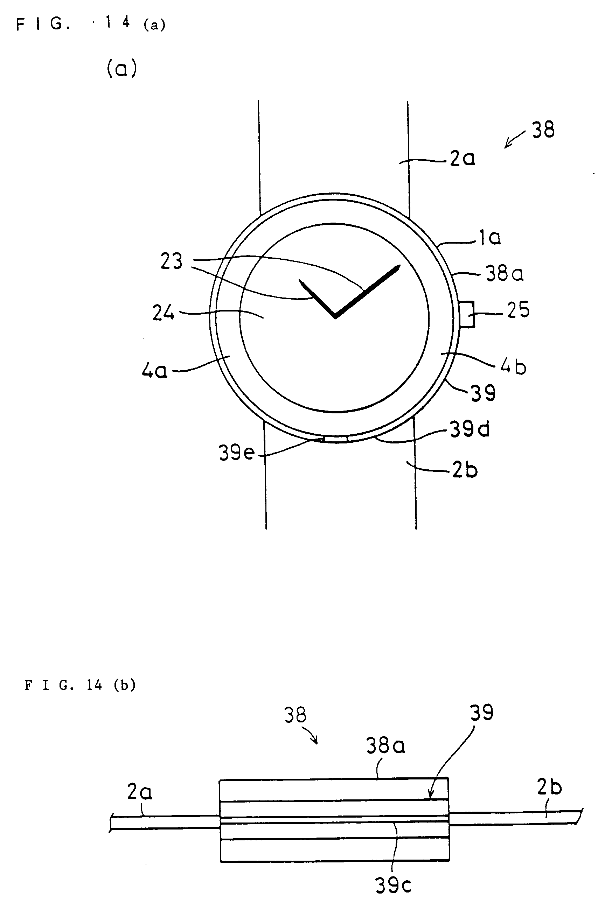

In the fifth embodiment of wrist-mounted portable radio set 38 (figure 14(a)), the main body 1a is of an analog watch having minute and hour hands 23 to indicate the time on a clock face 24, and a crown wheel 25. An antenna assembly 39 is arranged on the outer surface of an outer frame 38a of the clock face 24.

The antenna assembly 39 (figure 14(b)) is a slot antenna having a slot 39c facing to the outer surface from the outer frame 38a. The wrist straps 2a and 2b connecting to the main body 1a do not contain any antenna element. One end 39d (figure 14(a)) of antenna assembly 39 is located on the side of the outer frame 38a adjacent strap 2b, the antenna extends around the outer frame 38a, and the other end 39e of assembly 39 is located on the same side of the outer frame 38a.

In the portable radio set 38, the antenna assembly 39 is arranged outside around the main body 1a, therefore nothing is located outside it to shield the waves generated therefrom. The power feeding point to the antenna assembly 39 is located at the centre along the longer edge thereof which is disposed on the side of the frame adjacent the strap 2a. Nothing is arranged there to shield the wave generated from the feeding point. Therefore, in the portable radio set 38, the radiation energy of the wave is not attenuated. The image effect of the circuit board arranged in the main body 1a and the outer frame 38 itself upgrades the sensitivity.

Sixth Embodiment

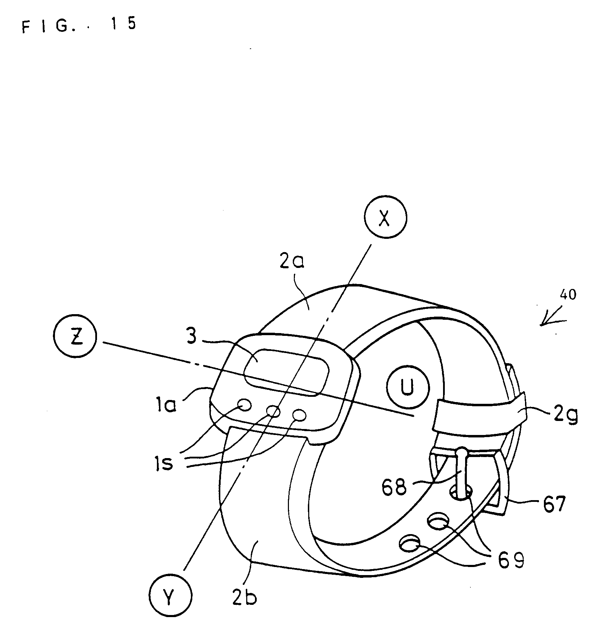

In the sixth embodiment of portable radio set 40 (figure 15), wrist-straps 2a and 2b are connected to the main body 1a thereof for mounting on user's wrist, and a data display unit 3 with external switches 1s is disposed on the front surface of the main body 1a. The wrist strap 2a has a buckle 67 at its distal end as a connecting means for the straps 2a and 2b. The wrist strap 2b has holes 69 into which a lock pin 68 of the buckle 67 can be selectively inserted. The wrist strap 2a also has a band 2g for holding the distal end of the wrist strap 2b.

This popular wrist watch connection mechanism cannot be used in a portable radio set with a loop antenna because the distal ends of wrist straps must be connected each other electrically to form the loop antenna using the electrically connected wrist straps. On the other hand, as the present portable radio set has a slot antenna element, in each of its wrist straps which do not require to be connected electrically to each other, the popular mechanism for connection of the wrist straps can be used.

In a wrist-mounted portable radio set having a loop antenna, the distal ends of the wrist straps are mechanically connected by the buckle to form the loop antenna and static electricity is transferred to the main body from the buckle. Some countermeasure is required to protect from the effect of the static electricity. As the present portable radio set 40 has the buckle 67 at the distal end of the wrist strap 2a electrically insulated from the antenna assembly 13, no countermeasure for static electricity is required, which enables the popular connection mechanism to be used.

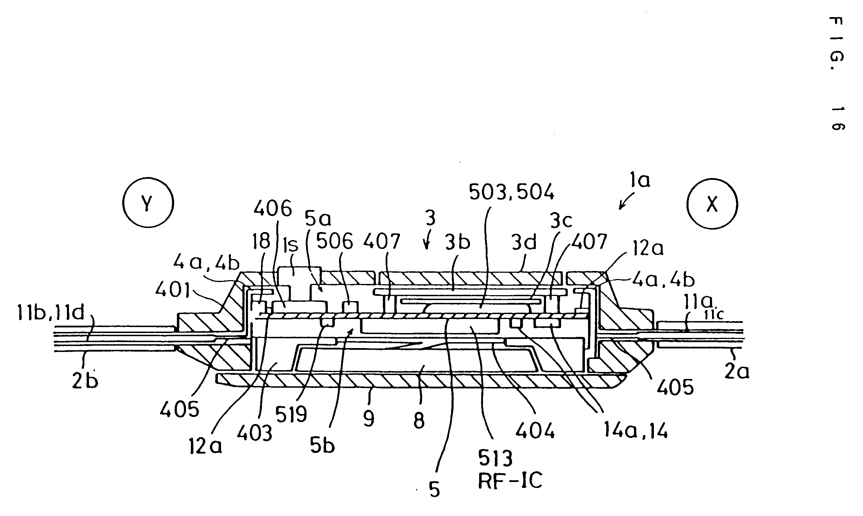

The wrist straps 2a and 2b (figure 16) contain the antenna elements 11a, 11c and 11b, 11d, respectively. The antenna element 11a and 11b are connected to the electrically conductive plate 4a disposed in the main body 1a. The antenna element 11c and 11d are connected to the electrically conductive plate 4b disposed in the main body 1a.

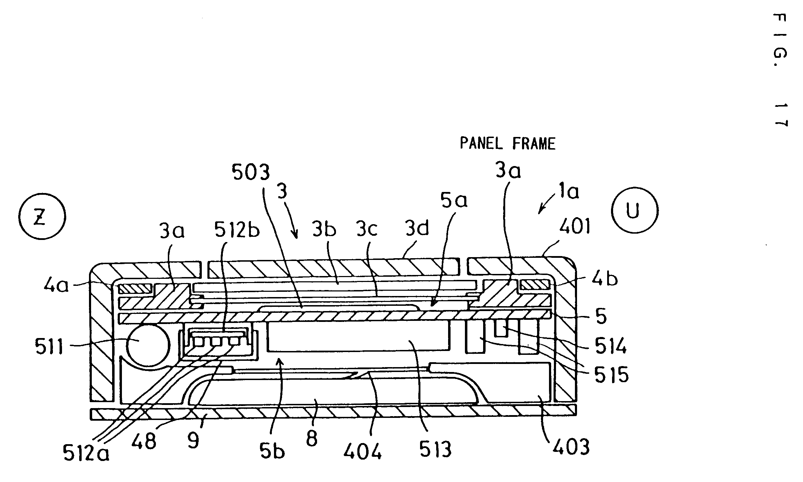

The main body 1a has a case 401 in which the circuit board 5 is horizontally disposed in the case 401. Each switch is connected to the circuit board 5 via an electrically conductive rubber piece 406. The main body 1a also has a panel frame 3a (figure 17) on the front side of the circuit board 5, the data display unit 3 is disposed between the panel frame 3a and the circuit board 5. The display unit 3 has a panel 3b electrically connecting to the circuit board 5 via electrically conductive rubber pieces 407 (figure 16). The main body 1a has a protective transparent lens 3d disposed on the front surface side of the panel 3b, and an optically reflective plate 3c for the panel 3b located between the panel 3b and the circuit board 5.

On the front surface side of the circuit board 5, the electrically conductive plates 4a and 4b are arranged, and to the ends thereof the ends of the antenna elements 11a to 11d are electrically connected via connecting pins 405 which penetrate the case 401. The electrically conductive plates 4a and 4b are connected to the front surface side of the circuit board 5 via terminal board 12a (only part of the electrically conductive plates 4a and 4b being shown). The electrically conductive plates 4a and 4b are arranged along the internal surface of case 401 to connect the antenna element 11a and 11b, and the antenna element 11c and 11d respectively.

In the main body 1a, a battery 8 is installed in a battery case 403 disposed on the rear surface side of the circuit board 5. The negative side of the battery 8 is connected to the ground pattern of the circuit board 5 via a electrode 404. The main body 1a also has a rear case 9 arranged on the rear surface side of the case 401 to close it.

The radio set 40 has a radio transmit/receive portion 102 similar to that of figure 5 or figure 6. Thus, the circuit board 5 has a decoder 503, a CPU 504, a digital circuit part 506 and other parts on the front surface side thereof from X to Y (figure 16). By this circuit, a digital circuit 5a (figure 17) is constituted. The circuit board 5 has, in order to realise the high frequency amplifier circuit 14 (RF amplifier), a circuit element 14a (figure 16), a RF-IC 513, analog circuit parts 519 and other parts disposed on the rear surface side thereof. The circuit board 5 (figure 17) has, in order to provide an analog circuit 5b, a chip capacitor 514, a tantalum capacitor 515, the RF-IC 513, a local oscillator 512a covered by a shield case 48 or the like on the rear surface side thereof from U to Z.

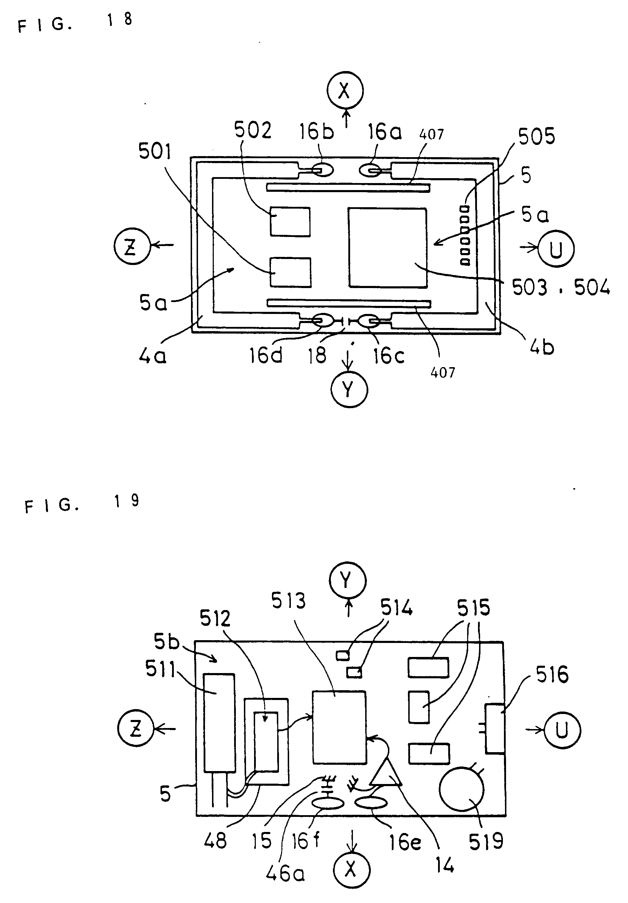

On the front surface side of the circuit board 5 (figure 18), the electrically conductive plates 4a and 4b are arranged along the outer edge thereof. The ends of the electrically conductive plate 4a and 4b are connected to the circuit board 5 at terminal points 16a to 16d. A capacitor 18 is connected between terminal points 16c and 16d. On the front surface side of the circuit board 5, constituting the digital circuit 5a, there are arranged a chip capacitor 505, decoder 503, CPU 504, DC-DC converter 501, EEPROM 502 and the other parts from U to Z. In the digital circuit 5a, all the circuits for processing digital data, such as a data decoding circuit, a central processing unit CPU, a data storage circuit, a data display circuit, a phase controlling circuit, and a phase comparing circuit, are provided. On the same side of the circuit board 5, the pieces 407 for panel driving of the data display unit 3 is arranged. The DC-DC converter 501 is located on the Z side of the circuit board 5 nearer the electrically conductive plate 4a than the plate 4b.

On the rear surface side of the circuit board 5 (figure 19), the analog circuit 5b is constructed of the tantalum capacitors 515, the high frequency wave amplifier 14, the chip capacitors 514, the RF-IC 513, the local oscillator 512 covered by the shield case 48 and a quartz crystal oscillator 511. The local oscillator 512 and the quartz crystal oscillator 511 are disposed on the end of Z side of the circuit board 5. On the rear surface side of the circuit board 5, there are also arranged a terminal point 16e for the high frequency wave amplifier 14, and a terminal point 16f connected to ground 15 via a capacitor 46a. The terminal point 16e is connected to the terminal point 16a located on the front surface side of the circuit board 5 via a through hole, so that the high frequency wave amplifier 14 is connected electrically to the electrically conductive plate 4b. The terminal point 16f is connected via a through hole to the terminal point 16b located on the front surface side of the circuit board 5, the ground voltage is supplied to the electrically conductive plate 4a. On the rear surface side of the circuit board 5, a buzzer 516 and a battery backup capacitor 519 are also installed.

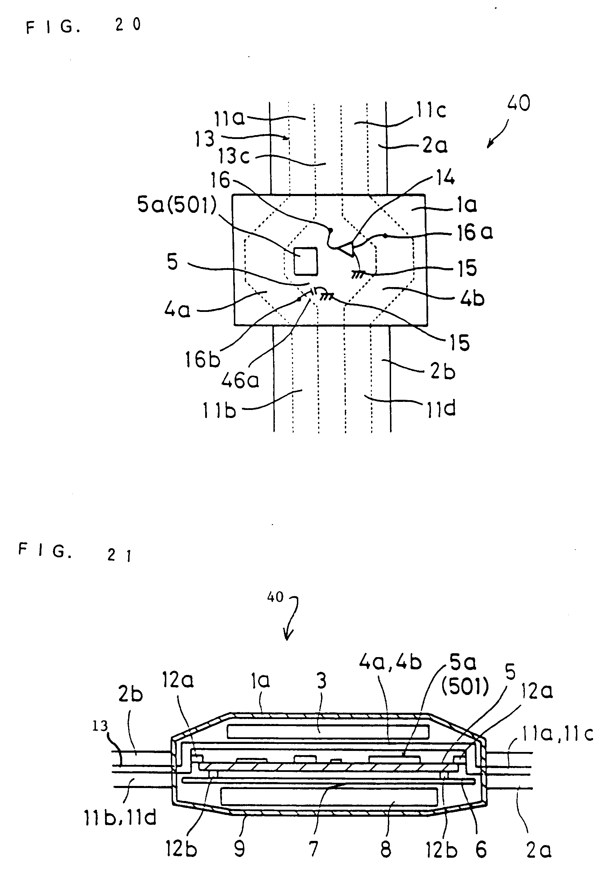

In the wrist-mounted portable radio set 40 (figure 20) the antenna assembly 13 is a slot antenna having the slot 13c is constituted by and located between pairs of the antenna elements 11a to 11d contained in the wrist straps 2a and 2b, and the electrically conductive plates 4a and 4b in the main body 1a. The electrically conductive plate 4a is connected via the terminal point 16b to the ground 15 of the circuit board 5. The electrically conductive plate 4b is connected via the terminal point 16a to the high frequency wave amplifier 14. Hence the high frequency wave amplifier 14 is connected to the electrically conductive plate 4a through the ground 15 of the circuit board 5. Therefore, the voltage of the electrically conductive plates 4a and 4b is unbalanced and the plates 4a and 4b have different voltage levels.

As the DC-DC converter 501 in the digital circuit 5a might be a noise source, it is located near the electrically conductive plate 4a. The quartz crystal oscillator 511 having a natural frequency of 90 MHz, and the local oscillator 512 in the analog circuit 5b might be noise makers and are therefore disposed near the electrically conductive plate 4a. Thus, the electrically conductive plate 4b is located relatively far from the noise makers such as the quartz crystal oscillator 511, the local oscillator 512 and the DC-DC converter 501. Even if noise is generated by the local oscillator 512, the DC-DC converter 501 or the like, the electrically conductive plate 4a is not affected by such noise, because the plate 4a has the low impedance at the high frequency wave band due to the connection to ground 15. The electrically conductive plate 4b has a high impedance at the high frequency band and is not affected by the noise so generated owing to its location relatively far from the noise sources.

In the portable apparatus such as radio, TV, receiver, pager, adopting the direct conversion detection method and using a direct conversion circuit or the like, the locally oscillator frequency is almost the same as the receiving frequency. Therefore, the antenna assembly 13 tends to catch its local oscillation signal as a noise which interferes with the transmitting and receiving among the portable radio sets.

In the wrist-mounted portable radio set 40, the local oscillator 512 is disposed, in the same way, as the DC-DC converter 501 in the digital circuit 5a, near the electrically conductive plate 4a having the low impedance at the high frequency band, that is far from the electrically conductive plate 4b having the high impedance at the high frequency band. Therefore, noise generated from the local oscillator 512 does not radiate outwardly.

In addition to the DC-Dc converter 501 and the local oscillator 512, the message processing portion 114 (figure 5), the P-ROM 106, the alarm driving circuit 107 and the other circuits among the circuitry 100 might be noise sources. Therefore, these circuits should be disposed far from the electrically conductive plate 4b having the high impedance at the high frequency band, so as not to enter the noise thereto.

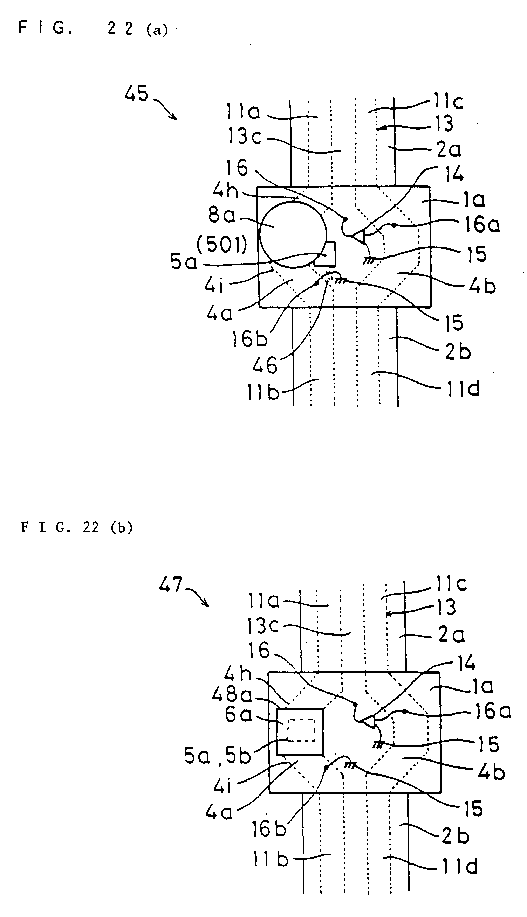

As will be seen from figures 3 and 21, the main constructional dispositions of the first and sixth embodiment are similar. Thus the circuit board 5 of the radio set 40 containing the high frequency ground pattern thereon is disposed on the rear surface side of the electrically conductive plate 4a and 4b as is the reflector plate 6. When the portable radio set 40 is mounted on a user's wrist, the rear case 9 thereof contacts the user's wrist, but the antenna assembly 13 is shielded by the rear case 9 and the reflective plate 6 from the wrist to prevent the effect of the human body.

Seventh Embodiment

A seventh embodiment of wrist-mounted portable radio set 45 (figure 22(a)) is similar to the first embodiment, and has an antenna assembly 13, which is a slot antenna having the slot 13c, constituted by antenna elements 11a to 11d contained in two wrist straps 2a and 2b arranged on either side of the main body 1a, and electrically conductive plate 4a and 4b installed in the main body 1a and connected with the antenna element 11a to 11d. In the main body 1a, the circuit board 5 with the high frequency ground pattern thereon and the reflective plate 6 are disposed on the rear surface side of the electrically conductive plates 4a and 4b in order to exert thereon reflective ability to focus the directivity of the antenna assembly to its front surface side. When the portable radio set 45 is mounted on a user's wrist, the rear case 9 thereof is in contact with the user's wrist. However, the antenna assembly 13 of the portable radio set 45 is shielded by the rear case 9 and the reflective plate 6 against the wrist, to prevent the effect of the human body.

The electrically conductive plate 4b is, as in the sixth embodiment, connected at the terminal point 16a to the high frequency amplifier 14 which is connected to the ground 15 of the circuit board 5. The electrically conductive plate 4a is connected at the point 16b to the ground 15 of the circuit board 5. The electrically conductive plates 4a and 4b are unbalanced in voltage level. The electrically conductive plate 4a is disposed nearer than the plate 4b to the noise sources, such as the DC-DC converter 501 in the digital circuit 5a.

The electrically conductive plate 4a is divided into two in the main body 1a. Both ends 4h and 4i of the divide in the plate 4a are connected to the negative side (grounding side) of the button type battery 8. Therefore, the impedance level of the present electrically conductive plate 4a is low.

In the portable radio set 45, noise sources, such as the DC-DC converter 501 are included in the digital circuit 5a. However, as in the sixth embodiment, the electrically conductive plate 4a having the low impedance is disposed bear the digital circuit 5a, whilst the electrically conductive plate 4b having the high impedance is disposed far from the digital circuit 5a. Therefore, the electrically conductive plates 4a and 4b are so arranged to prevent interference by noise generated from the digital circuit 5a. The portable radio set 45 has the same effect as described for the sixth embodiment.

Both ends 4h and 4i of the divide in the electrically conductive plate 4a can be connected to the positive side of the battery 8 if desirable for the circuit for processing the high frequency wave. To use these connections, a capacitor 46 for the reactance element having a low impedance at the high frequency band should be inserted between the point 16b of the electrically conductive plate 4a and the ground 15, as shown in figure 22(a) by dotted lines.

Eighth Embodiment

The eighth embodiment of wrist-mounted portable radio set 47 (figure 22(b)), is similar to the sixth embodiment, in that electrically conductive plate 4b is connected at the point 16a to the high frequency amplifier circuit 14 which is connected to the ground 15 of the circuit board 5. The electrically conductive plate 4a is disposed near the noise sources in the digital circuit 5a and in the analog circuit 5b.

The electrically conductive plate 4a is divided into two part in the main body 1a. Both ends 4h and 4i of the divide in the plate 4a are connected to a shielding case 48a for shielding the noise sources located in the digital circuit 5a and in the analog circuit 5b. Accordingly the impedance of the electrically conductive plate 4a is low. The shield case 48a can be connected to either side negative (cathode) or positive (anode) of the battery 8. If the shield case 48a is connected to the positive side of the battery, a capacitor having a low impedance should be inserted between the point 16b and the ground 15 as with the seventh embodiment.

Noise leaking from the shielding case 48a may not affect the electrically conductive plate 4a and 4b, as the plate 4a having the low impedance is disposed near the shielding case 48a and the plate 4b having the high impedance is disposed far from the shielding case 48a.

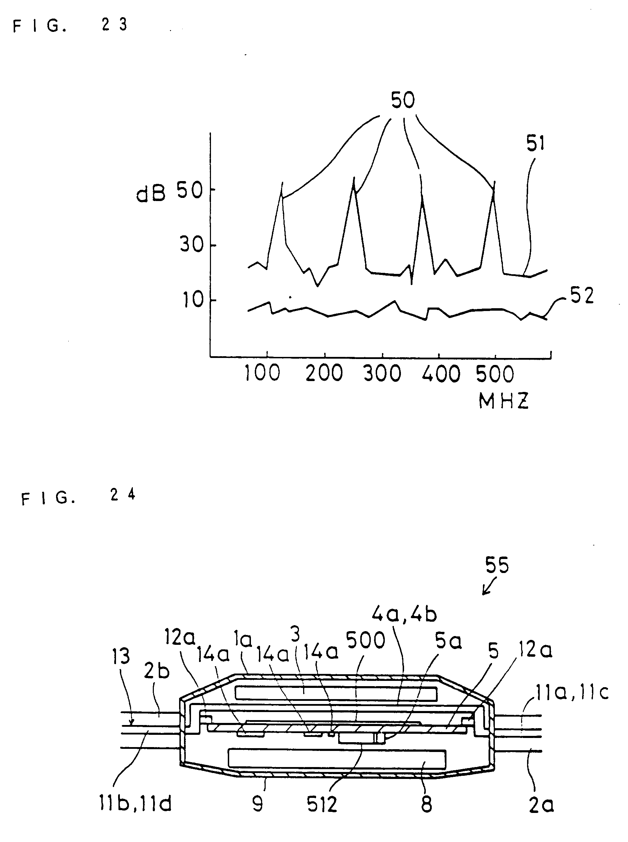

If the super heterodyning is applied as shown in figure 6(a), a noise having a frequency of $\underline{n}$ times the signal frequency generated from the reference oscillator 210, where $\underline{n}$ is an integer, is generated. Thus if the oscillator frequency is 50 kHz, the noise has a frequency of $50\underline{n}$ kHz. If the direct conversion method is applied as shown in figure 6(b), a noise is generated at the quartz crystal oscillator in the local oscillator 307 (with similar effect). These noises are shown in figure 23 as solid line 50. In figure 23, the solid line 51 shows the level of the other digital noise generated in the digital circuit. Both noises 50 and 51 are at relatively high level of decibels. Where the direct conversion method is applied, as the tuning frequency of the antenna assembly 13 should be the same of the oscillation frequency of the local oscillator, the oscillated signal from the local oscillator may easily enter into the antenna assembly 13. However in the embodiments of the present invention, which have the electrically conductive plate 4b with the high impedance at the high frequency band disposed far from the noise sources, the noises cannot be caught easily by the antenna assembly 13. Consequently, the noise level caught by the antenna assembly 13 can be reduced to the level shown in figure 23 by solid line 52.

Ninth Embodiment

The ninth embodiment of portable radio set 55 (figure 24) is similar to the sixth embodiment, but in order to protect the antenna assembly 13 from the noise generated in the local oscillator 512 in the main body 1a, the radio set 55 has the local oscillator 512 disposed on the rear surface side of the circuit board 5, and the ground pattern surface 500 provided either on the front surface or the rear surface of the circuit board 5 to cover the front surface area of the local oscillator 512. In addition, the rear surface area of the local oscillator 512 is covered by the battery 8. As the rear surface of the battery 8 facing to the rear case 9 is its positive side, the rear surface area of the local oscillator 512 is covered by the negative side (ground side) thereof. Using the above arrangement, the local oscillator 512 can be covered by the components having the same electrical potential level to get a better shielding effect against the noise generated in the local oscillator.

Tenth Embodiment

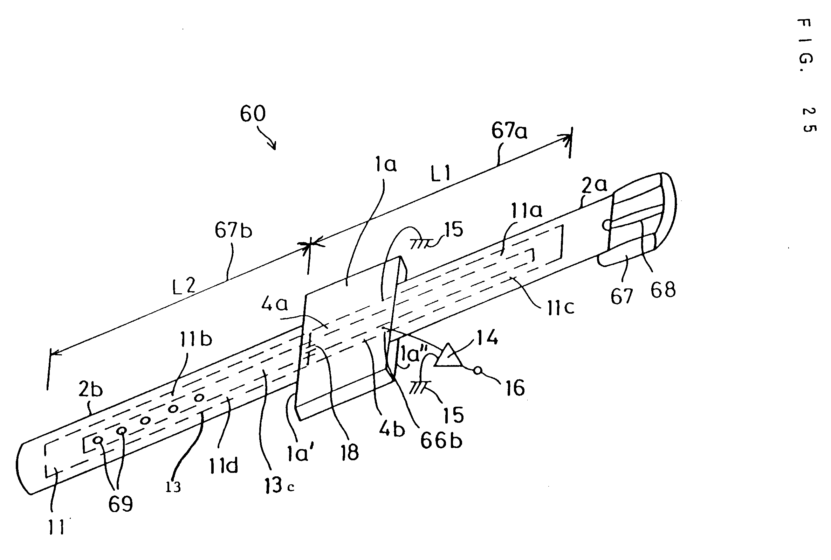

The tenth embodiment of wrist-mounted portable radio set 60 (figure 25) has a main body 1a and wrist straps 2a and 2b connectible by a buckle 67 as has the sixth embodiment. The buckle 67 on the distal end of the strap 2a has a lock pin 68 to be inserted into a selected hole 69 in the strap 2b. The holes 69 are located along the length of the slot 13c between the antenna elements 11b and 11d in the strap 2b.

In the portable radio set 60, the length of the wrist strap 2b is longer than that of the strap 2a, so that the antenna elements 11b and 11d contained in the strap 2b are longer than the elements 11a and 11c contained in the strap 2a. However in the antenna assembly 13, the portion 67a including the antenna elements 11a, 11c and the electrically conductive plates 4a, 4c has a length L1 equal to the length L2 of a portion 67b including the antenna elements 11b and 11d. The portions 67a and 67b meet at one edge 1a' of the main body 1a, to which the wrist strap 2b is connected, and which is the six o'clock position in a wrist watch. The capacitor 18 which must be installed on the centre of the longer side of the antenna assembly 13, can be connected to the antenna assembly 13 in the main body 1a at the edge 1a'.

The wrist strap 2a is joined to the main body 1a at the other edge 1a'' which is at the twelve o'clock position. At the edge 1a'' in the main body 1a, the electri-

cally conductive plate 4a is connected to ground 15, and the other electrically conductive plate 4b is connected to the high frequency wave amplifier circuit 14 at an electrical power feeding point 66b, which is thus spaced from the connecting point of the capacitor 18.

The high frequency wave amplifier circuit 14 is connected via the terminal 16 to the downstream circuits whose constitution and operation are as similar to those shown in figure 5.

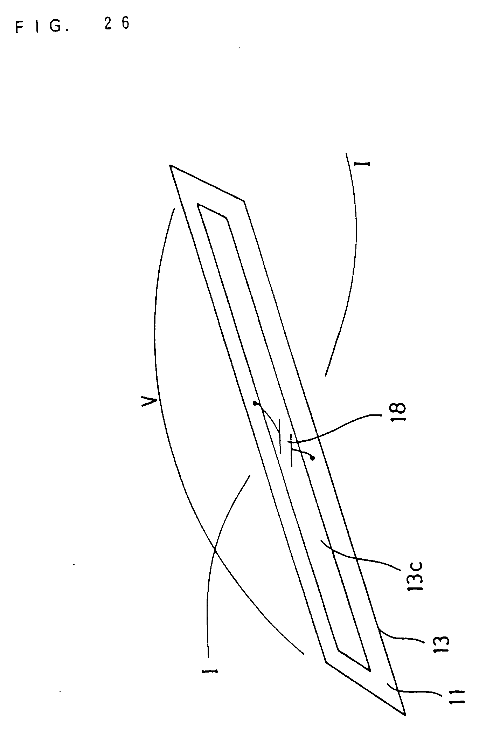

As the slot antenna assembly 13 (figure 26) is of the magnetic flow type, the voltage distribution is indicated by the solid line V and the current distribution by the solid line I. The impedance Z at the location of the antenna plate 11 is given by the following equation

$$Z = V/I$$

According to the above equation, the impedance of the antenna plate 11 near the capacitor 18 becomes very high, and the input impedance of the amplifier circuit 14 is between 50 and 100Ω. Therefore, in order to get impedance matching between the amplifier circuit 14 and the antenna assembly 13, the impedance of the antenna assembly 13 must be low. Thus, because the power feeding point 66b can be located at the position different from the connecting point of the capacitor 18, impedance matching can be made if that position is selected where the impedance of the plate 11 is lower.

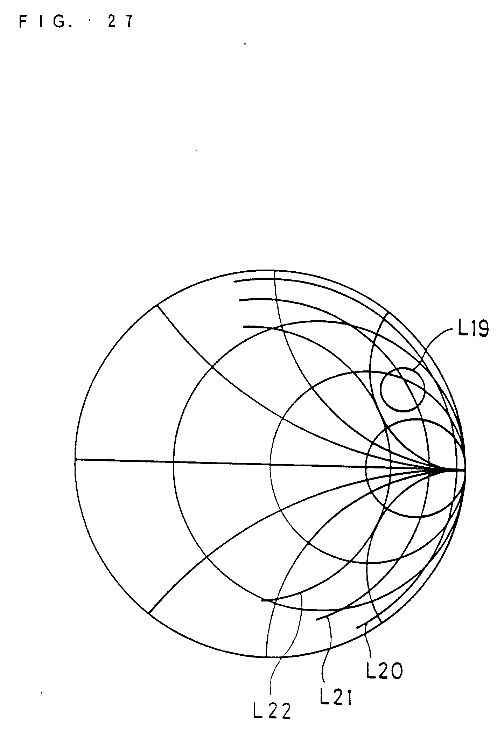

In a graph (figure 27) of a property of the input impedance of the antenna assembly 13 depending on the power feeding position 66b, the solid line L20 is the property of the input impedance if the power feeding position 66b is located near the connecting point of the capacitor 18. The solid line L21 is the property of the input impedance if the power feeding position 66b is located near the centre of the portion 67a containing the antenna element 11a and 11c. The solid line L22 shows the property of the input impedance if the power feeding position 66b is located near the distal end of the antenna elements 11a and 11c. A circular solid line L19 shows an optimum impedance range for the high frequency wave amplifier circuit 14. Thus, the property of the input impedance shown by the line L21, which crosses the circular portion L19, is preferable. To achieve such property, the power feeding position 66b should be moved from the connecting point of the capacitor 18 to near the middle point of the portion 67a containing the antenna element 11a and 11c.

Where the power feeding point 66b is located in the position which only achieves the property of line L20 or line L22, some other matching circuits are required to equalise the impedance of the antenna assembly 13 and the high frequency wave circuit 14. There are some problems in providing such matching circuits, such as the necessity for additional element and other parts constituting a circuit. Where the power feeding point 66b is moved from the connecting point of capacitor 18 to the position at which the optimum impedance can be achieved, impedance matching can be done easily without additional elements or other parts.

The wrist-mounted portable radio set 60 using a longer and a shorter wrist strap enables the capacitor 18 to be connected near one edge 1a', and the feeding point 66b near the other edge 1a" of the main body 1a, thus separating the connecting points by the width of the main body 1a. Thus, the radio set 60 enables the capacitor 18 to be connected to the lengthwise centre of the antenna assembly 13, and the feed point 66b to be located at a position sufficiently separated therefrom.

Eleventh Embodiment

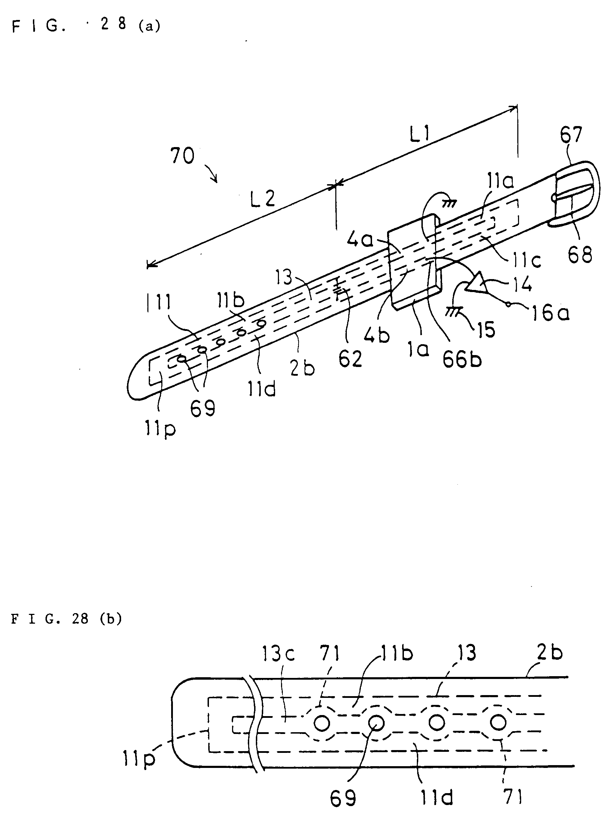

In the eleventh embodiment of wrist-mounted portable radio set 70, (Figure 28(a)), the antenna elements 11b and 11dare longer than the antenna elements 11a and 11c, as in the tenth embodiment, but longitudinal, a capacitor 62 is installed at the centre point of the longer side of the antenna assembly 13, which lies in the wrist strap 2b in which the antenna elements 11b and 11d are contained.

In order to increase the connection strength between straps 2a and 2b, the holes 69 (Figure 28(b)) in the strap 2b have generally the same diameter as the width of the slot 13c. The antenna elements 11b and 11d contained in the band 2b have portions 71 shaped to increase the width of the slot 13c in the vicinity of the holes 69, so as to avoid contact between antenna elements and the pin 68 of the buckle 67. Thus, the antenna elements 11b and 11d have narrower portions. However, the sensistivity of the antenna assembly 13 is not decreased because the current distribution of the antenna elements is concentrated on the distal end 11p.

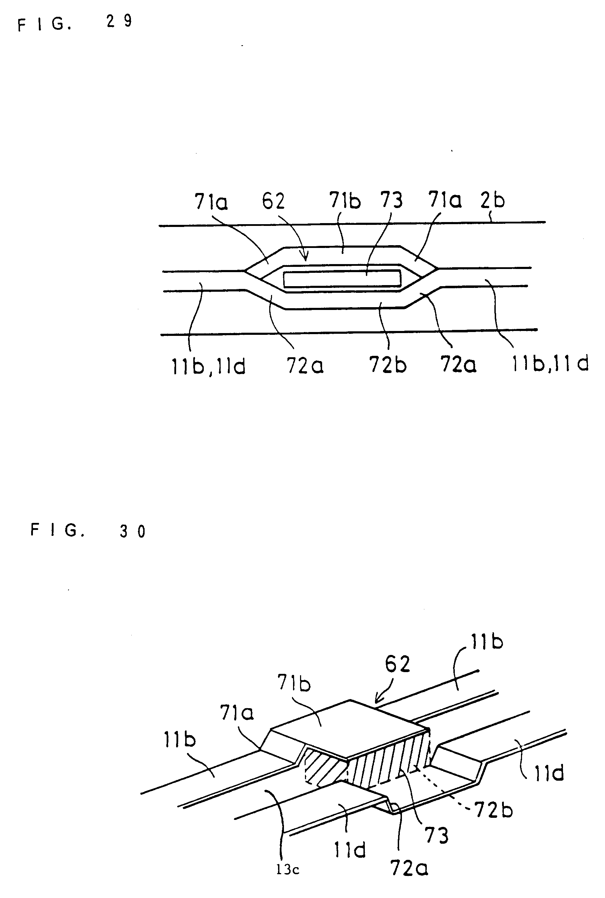

In the portable radio set 70, the antenna elements 11d are used as parts of the capacitor 62 (figure 29) in the wrist strap 2b. The antenna element 11b has stepped portions 71a and a raised portion 71b therebetween which projects over the slot 13c. The antenna element 11d has stepped portions 72a and a lowered portion therebetween which projects across the slot 13c under the portion 71b. Dielectric material 73 (figure 30) is injected into space between the portions 71b and 72b. Where the area of overlap between the portions 71b and 72b is S, the dielectric constant in a vacuum condition of the dielectric material is $\varepsilon$ o, the specific dielectric constant of the dielectric material is $\varepsilon \tau$, the distance between portions 71b and 72b is d, the capacitor 62 has a capacitance C shown by the following equation

$$C = \varepsilon o \cdot \varepsilon_r \cdot S/d$$

Accordingly, the capacitor 62 can be disposed outside of the main body 1a and need not necessarily be installed inside the main body 1a. Hence, whether the main body 1a is located at the centre of the longer side of the antenna assembly 13 or not, the capacitor 62 can be installed as its centre, so as to upgrade its sensitivity. As the main body 1a should not be located at the centre of the longer side of the antenna assembly 13, the main body la can be moved to locate the feeding point 66b at the optimum position for impedance matching without any effect on the position of the capacitor 62.

As the dielectric material 73 can be selected among a hide, silicone resin, urethane resin and the like, the material for the wrist straps 2a and 2b can also be accepted as the dielectric material. Therefore, the capacitor 62 can be introduced into the strap 2b or 2a during the fabrication process. Where the specific dielectric constant $\varepsilon$ r of the material for the straps 2a and 2b is in the range 3 to 5, the area S of overlap between the portions 71b and 72b is 25 mm$^2$, theand the distance d between the portion 71b and 72b is 0.3 mm, the capacitance C is in the range 2 to 4 pF and that is sufficient for the capacitor 62 applied to the wrist-mounted portable radio set 70 operated under the ultra high frequency UHF band.

Twelfth Embodiment

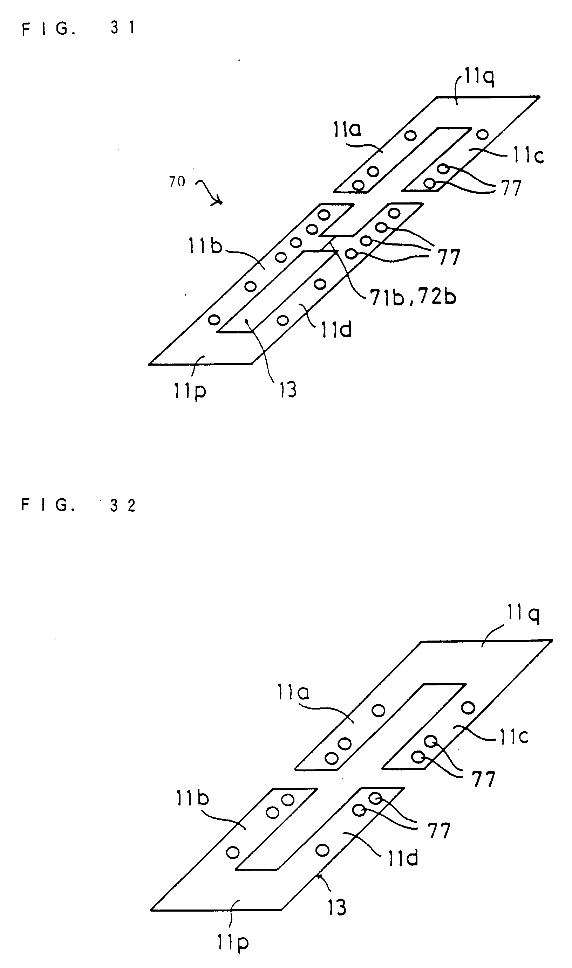

In a twelfth embodiment of wrist-mounted portable radio set 70 (Figure 31), the antenna assembly 13 has holes 77 through the antenna elements 11a, 11b, 11c and 11d. If the antenna assembly 13 includes a capacitor 62 as in the eleventh embodiment, the spacing of the holes 77 increases away from the overlap portions 71b and 72b constituting the capacitor 62. Thus the concentration of the apertures 77 is rather high around the portions 71b and 72b, but decreases towards the distal ends 11p and 11q of the antenna elements, with no opening in the distal ends lip and 11p and 11q.

In a portable radio set, the impedance around the portions 71b and 72b is high, so that it is affected by the human body when mounted on the user's wrist. This causes mismatch of impedance between the antenna assembly 13 and the high frequency amplifier circuit 14 connected thereto, so that the sensitivity of the portable radio set is decreased. However, in the portable radio set 70, the holes 77 in the area having high impedance reduce the surface facing area upon the human body, so that the effect of the human body on the portable radio set is minimised. Around the portions 71b and 72b, the current distribution is small so that the openings 77 do not cause increase of resistance. At the distal ends 11p and 11q of the antenna assembly 13, where the current distribution is high, no hole 77 is made in order to prevent an increase in resistance.

If the capacitor 62 constituted by the portions 71b and 72b of the antenna assembly 13 is not used (Figure 32), the spacing of the holes 77 decreases towards the centre of the longer side of the antenna assembly 13 and increases towards the distal ends 11p and 11q so as to prevent or reduce the effect of the human body.

Thirteenth Embodiment

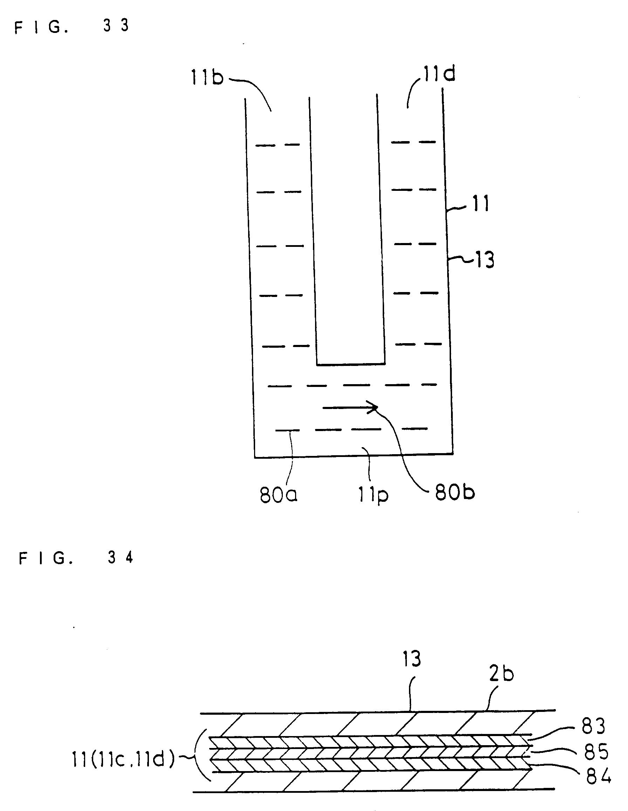

The thirteenth embodiment (Figures 33 and 34) includes a special antenna assembly which may be used in any of the first to twelfth embodiment. The antenna assembly 13 has improved electrical property and such improvement is achieved by a manufacturing process.

The antenna plate 11 is made of a stainless material or the other material having sufficient stiffness and corrosion resistance by a rolling process in which the material is stretched under pressure. Thus, the antenna plate 11 has slight undulations on its surface, as indicated in Figure 33 by dotted lines 80a corresponding to the peaks of such undulations. When a high frequency signal goes through the antenna plate 11, the corresponding current flows in the surface or skin of the antenna plate 11 according to the skin effect. The skin depth $\delta$ which is the depth of the current permeated into the antenna plate 11, is calculated using the following equation with the magnetic permeability in vacuum condition $\mu$ o of the material, the frequency f of the high frequency signal, and the electrical conductivity $\sigma$ of the material.

$$\delta = 1/\sqrt{(\pi \cdot f\mu o \cdot \sigma)}$$

Accordingly, the lost of resistivity of the antenna plate is decreased in this embodiment because the direction of the peaks of the undulations is the same as that of the current indicated by arrow 80b.

The antenna plate 11 (Figure 34) has an upper layer 83, a middle layer 85 and a lower layer 84, each with different rolling directions so that the bending strength of the antenna plate 11 is high.

The antenna plate 11 (Figure 34) has the upper layer 83 and the lower layer 84 in both the distal end portions 11p, are rolled in a direction such that the peaks of the undulations shown by the dotted line 80a made by the rolling process coincide with the direction of the current shown by the arrow 80b. In the middle layer 85, the direction of the undulations crosses perpendicularly the direction of current shown by arrow 80b. The antenna plate 11 does not break even if the large force is repeatedly applied when the wrist-mounted portable radio set is mounted on the wrist.

Fourteenth Embodiment

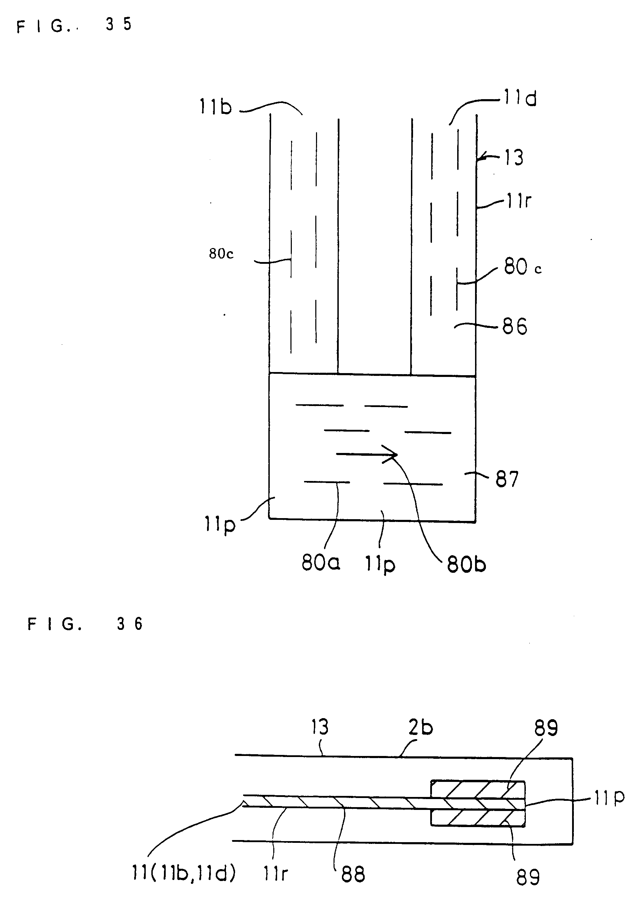

In a fourteenth embodiment, in order to keep the strength of the antenna assembly 13 high and to reduce its resistivity loss, the portions 11r (Figure 35) of the antenna elements of the antenna plate 11 at which a large force is applied when the wrist-mounted portable radio set is mounted on the wrist, are made of a plate member 86 rolled in a direction to give undulations whose peaks are in a direction indicated by broken lines 80c, that is in a longitudinal direction. The distal portion 11p at which the electrical distribution is large is made of a plate member 87 which is rolled to have direction of the peaks of undulations shown by the dotted line 80a, the same as that of the current shown by the arrow 80b.

Fifteenth Embodiment

In a fifteenth embodiment (Figure 36), the portion 11r of the antenna plate 11 at which a large force is applied when the wrist-mounted portable radio set is mounted on the wrist is made of a plate member 88 of a material selected for strength, and the distal portion 11p at which the electrical distribution is large is made of the plate member 88 which is coated or plated with a high conductivity material layer 89, such as copper or silver. The thickness of the coated layer 89 must be higher than the skin depth $\delta$ which is the depth of the current permeated into the antenna plate 11.

Sixteenth Embodiment

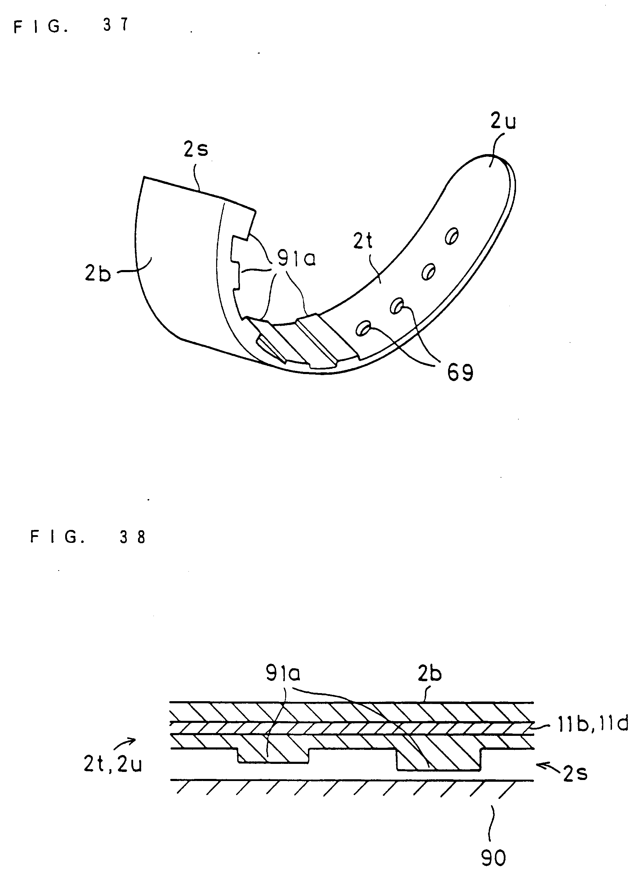

In a sixteenth embodiment (Figures 37 and 38), the wrist strap 2b has a plurality of raised portions 91a across its length on its wrist-engaging surface. The portions 91a start from the end 2s connected with the main body 1a and continue near the distal portion 2t having the holes 69. The height of the raised portions 91a gradually decreases from the end 2s to the distal end 2t of the wrist strap 2b. This feature may be applied to any of the first to fifteenth embodiments.

As the portions of antenna elements 11b and 11d located at the end 2s of the wrist strap 2b have relatively high impedance's, they tend to be effected by the human body. However, the provision of raised portions 91a at the end 2s keeps a certain space between the antenna elements 11b and 11d and the user's wrist 90 (Figure 38). As the impedance at the distal end 2u of the wrist strap 2b is low and the effect of the human body is negligible, the raised portions 91 a thereon are lower or non-existent so that a user can fix the wrist straps easily. As the end 2s of the wrist strap 2b has larger radius of curvature than other parts thereof when it is mounted on the wrist, the lower raised portions 91a on the end 2t of the strap makes bending easier.

By holding the portion of the antenna elements 11b and 11d having high impedance spaced from the user's wrist 90, impedance shift of the antenna assembly when so mounted can be prevented. Therefore, a portable radio set having this feature has high sensitivity.

## Seventeenth Embodiment

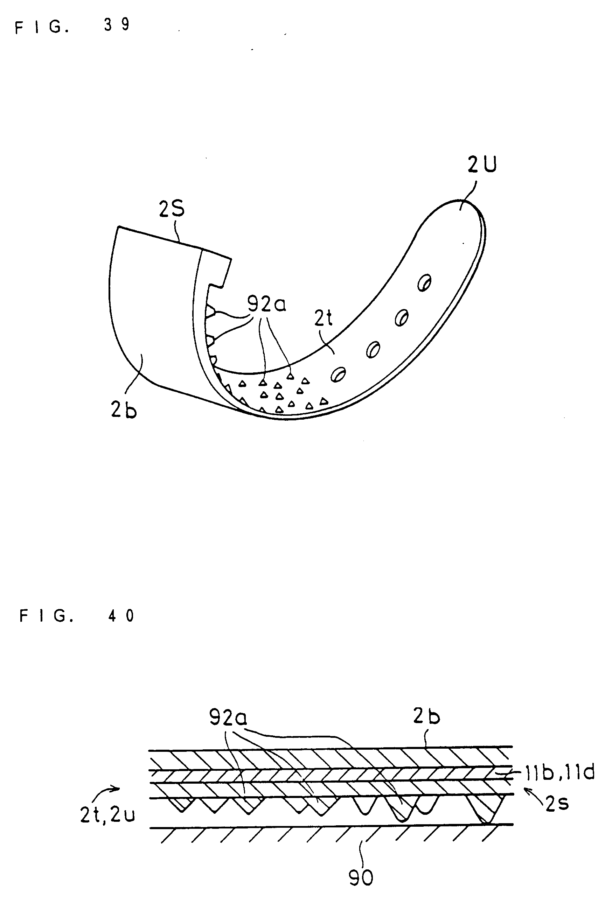

In a seventeenth embodiment (Figures 39 and 40) the wrist strap 2b has a plurality of generally hemispherical, conical or frustoconical projections 92a on its wrist-engaging surface instead of the raised portions 91a of the previous sixteenth embodiment. The projections 92a arranged on the end 2s of the antenna elements 11b and 11d connected with the main body 1a and having high impedance, have greater height in order to keep a certain space between the human wrist 90 and the antenna elements 11b and 11d so as to prevent the effect of the human body. In a wrist-mounted portable radio set, including this feature, the effect of the user's wrist 90 on the portion having the highest impedance in the antenna plate 11 is prevented, so that its antenna impedance does not shift and it can retain high sensitivity. The relatively lower projections 92a towards the distal end 2t of the wrist band make it easy to bend.

## Eighteenth Embodiment

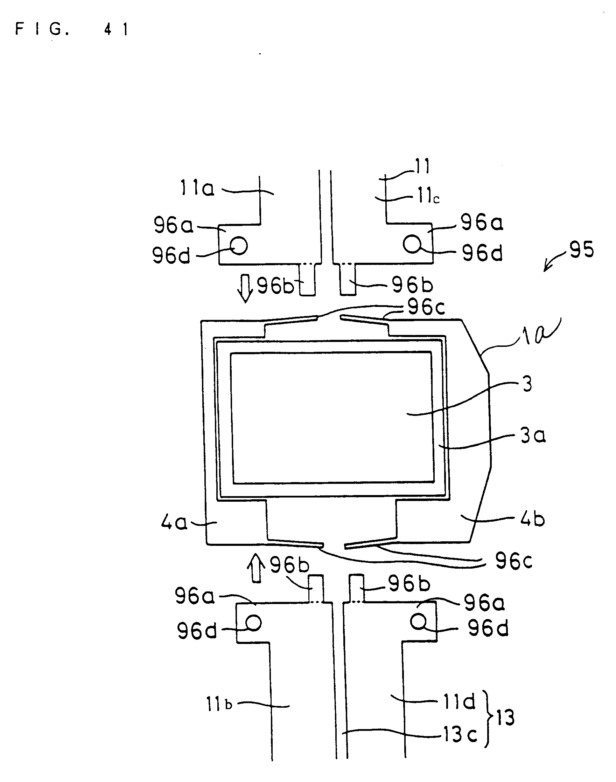

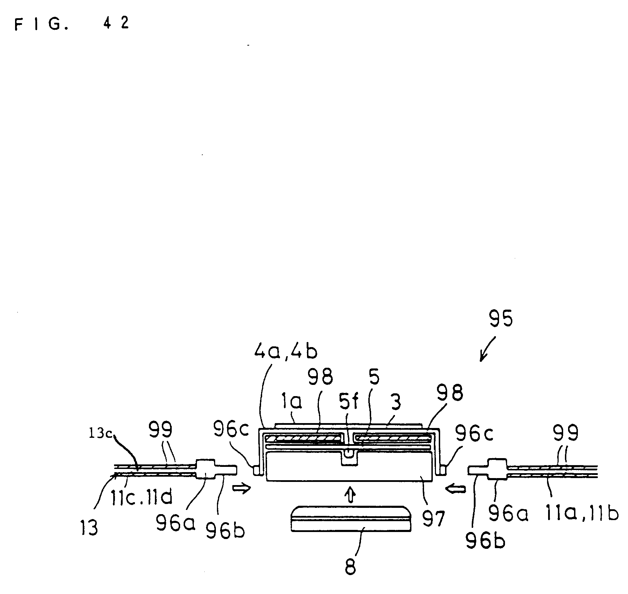

In an eighteenth embodiment of wrist-mounted portable radio set 95 (Figures 41 and 42), two wrist straps (not shown) are attached to either end of a main body 1a. The main body 1a has a data display unit 3 for displaying information on the front surface thereof, a panel frame 3a around the data display unit 3, and electrically conductive plates 4a and 4b on either side of the frame 3a. The portable radio set 95 has an antenna assembly 13 constituted by an antenna plate 11 composed of two pairs of antenna elements 11a to 11d contained in the pair of wrist bands and the two electrically conductive plates 46a and 46b. Each of the antenna elements 11a to 11d has at its end adjacent the main body, fixed plate 96a at the side and a contact pin 96b at the end 11a to 11d. At each end of the electrically conductive plates 4a and 4b is a spring plate 96c. The electrically conductive plates 4a and 4b are secured to the antenna elements 11a to 11d with the pins 96b in electrical contact with the plates 96c, by screws which pass through screw hole 96d made in the plates 96a.

The main body 1a (Figure 42) contains the data display unit 3, a circuit board 5 with circuits thereon, a battery frame 97, a battery 8, and rear case (not shown). The electrically conductive plates 4a and 4b are disposed beside the data display unit 3, and the circuit board 5 is located on the rear surface side of the electrically conductive plates 4a and 4b.

The main body 1a has a high dielectric material layer 98 on the rear surface side of the electrically conductive plates 4a and 4b made of BaO-TiO$_2$ or TiO$_4$ or BaO$_3$ or a mixture thereof, a low loss dielectric ceramic layer or the like. Other similar dielectric material layers 99 are disposed on the front surface side and rear surface side of the antenna elements 11a to 11d, and are injected into the slot 13c between the respective antenna element 11a to 11d. Ceramics, such as those specified have a specific dielectric constant in the range 8 to 40, which is higher than that of polyester resin (specific dielectric constant is 3.2 to 4.8) or of silicone resin (specific dielectric constant is 3).

As the portable radio set 95 has the circuit board 5 disposed on the rear surface side of the electrically conductive plates 4a and 4b, it has the same advantages as other embodiments in that the radiation wave can be radiated therefrom without shielding by the circuit board 5. The portable radio set 95 also has the high dielectric material layers 98 and 99 around the electrically conductive plates 4a and 4b, and antenna elements 11a to 11d. The wave length λ' in such high dielectric material can be derived from the following equation using a wave length λ and specific dielectric constant ε of the dielectric material.

$$\lambda' = \lambda/\sqrt{\varepsilon}$$

Therefore, the wave length λ' is shortened if the dielectric constant ε in the dielectric material is high.

Accordingly, where the dielectric constant ε of the dielectric material is high, this has the same effect as making the length of the slot 13c in the assembly 13 long. Therefore, the antenna gain for the radiation wave for the longer wave length can be maintained without elongating the length of the slot 13c, which would involve elongating the length of the antenna assembly 13.

## Other Embodiments

The high dielectric material layers 98 and 99 can be applied to the other embodiments of wrist-mounted portable radio set described hereinbefore.

A wrist-mounted portable radio set according to the invention can be provided with any combination of the characteristics explained hereinbefore. For example, a wrist-mounted portable radio set having the characteristics of the first, sixth, tenth, thirteenth or sixteenth embodiment, has the effect that the radiation wave from the antenna assembly is not shielded because the circuit board is not disposed on the front surface side of the antenna assembly. As the antenna assembly has the high impedance side arranged far from the noise source involved in some circuit, and the low impedance side arranged near the noise source, entering noise to the antenna assembly can be prevented. As the antenna assembly has a pair of different length portions connected to the portable radio set, the optimum location of the feeding point can be selected. The antenna assembly also has a high impedance part having the thicker rear side of the wrist band, therefore the effect thereon of the human body can be reduced. At the same time, the resistive loss of the antenna assembly can be reduced. Such a wrist-mounted portable radio set in accordance with the present invention can have high sensitivity.

As explained the above, according to the present invention, the antenna assembly is disposed on the front surface side of the circuit board in the main body. Therefore, the above arrangement eliminating the circuit board and other from the front surface side of the antenna assembly can prevent the shielding effect on the radiation wave from the antenna assembly.

The antenna assembly may be disposed on the outer frame of a wrist-mounted portable radio set, so that the antenna slot made along the length of antenna assembly faces outwardly. By this arrangement, no member is located on the front surface side of the antenna assembly so that the sensitivity of the antenna can be increased.

When the one side portion among the parts of the antenna assembly facing another side portion of that with respect to the slot, having the connection to the reference voltage side of the high frequency wave amplifier circuit is disposed near the noise source, and another portion having the connection to the signal voltage side of the high frequency wave amplifier circuit is disposed far from the noise source, the noise does not enter into the antenna assembly so that the sensitivity of the portable radio set of this invention can be upgraded. Especially if the direct conversion method is applied, the tuning frequency of the antenna assembly must be the same as the oscillation frequency of the local oscillator, and its noise tends to enter the antenna assembly. However, as explained in the above embodiment, if the local oscillator is installed rather far from the part of antenna assembly having the high impedance at the high frequency band, the effect of the noise on the radio itself and on other radios can be reduced.

Where the antenna assembly has different length antenna element with respect to the main body and which are fixed in the wrist straps, high sensitivity can be realised if the feeding point in the main body can be set at the optimum position separated from the reactance element.

Introducing high density openings in the portion of the antenna elements near the connecting point of the reactance element, or making thick wrist strap on its rear surface side there can moderate the effect of the human body, so as to keep impedance matching to a fine level to enhance sensitivity.

According to the construction for reducing the resistivity loss of the high frequency current at the distal end of the antenna assembly, an antenna device having high sensitivity can be provided.

**Claims**

1. A wrist-mountable electronic device, comprising a main body (1a) having a front surface facing away from a wearer in use, and a rear surface facing towards the wearer in use, and a circuit board (5) therein, and an antenna device comprising a slot antenna (13; 39) connected to the circuit board, the slot antenna including antenna elements (11A, 11B) located in wrist straps (2a, 2b) attached to the main body (1a), and electrically conductive members (4a, 4b) connecting the antenna elements (11A, 11B) and located within the main body (1a), in which the electrically conductive members (4a, 4b) are spaced from and on the side of the circuit board (5) closer to the front surface of the main body (1a); characterised in that the main body (1a) contains a reflective plate (6) to enhance the antenna gain effect, the reflective plate (6) being located in the main body (1a) on the side of the circuit board (5) closer to the rear surface of the main body (1a).

2. A device as claimed in claim 1, characterised in that the main body (1a) has a display unit (3) adjacent to and visible from the front surface of the main body (1a), and the antenna element connecting members (4a, 4b) are disposed along outside edges of the display unit (3).

3. A device as claimed in claim 2, characterised in that the antenna element connecting members (4a, 4b) are located closer to the front surface of the main body (1a) than the display unit (3) and are of substantially transparent thin film.

4. A device as claimed in claim 1, characterised in that the antenna (39) is located around an outer frame (38a) of the main body (1a) with its slot (39c) extending peripherally of the outer frame (36a).

5. A device as claimed in any preceding claim, characterised in that the antenna element connecting members (4a, 4b) are separated by the antenna slot, and one member is connected to a reference voltage side of a high frequency wave amplifier on the circuit board (5), and the other member is connected to a signal voltage side of the amplifier, the other member being further from noise sources in circuits on the circuit board (5) than the one member.

6. A device as claimed in claim 5, characterised in that the one member is connected to the reference voltage side through a reactance element.

7. A device as claimed in claim 5 or 6, characterised in that the circuits on the circuit board (5) include a local oscillator on the rear surface side of the circuit board (5).

8. A device as claimed in claim 7, characterised in that the local oscillator is surrounded by a plurality of parts at the same voltage level.

9. A device as claimed in claim 5, 6, 7 or 8, characterised in that the one member is electrically connected to a power source for driving the circuits on the circuit board (5).

**10.** A device as claimed in claim 5, 6, 7, 8 or 9, characterised in that the one member is electrically connected to a shield member by which the noise sources are covered.

**11.** A device as claimed in any preceding claim, characterised by a reactance element (62) connecting the portions of the antenna across the slot at the central longitudinal point thereof.

**12.** A device as claimed in claim 11, characterised in that the antenna elements (11A, 11B) have different lengths, the connecting point to the antenna being within the main body (1a) and offset from the reactance element connecting position.

**13.** A device as claimed in claim 12, characterised in that the shorter element (11A) is located in the wrist strap (2a) having a pin-type buckle (67,68) for connecting the wrist straps together, and the longer element (11B) is located in the wrist strap (2b) with at least one hole (69) for receiving the pin (68) of the buckle (67).

**14.** A device as claimed in claim 13, characterised in that the hole or holes (69) is or are located at the cross-wise centre of the slot.

**15.** A device as claimed in claim 14, characterised in that the slot has a widened portion (71) at the or each pin-receiving hole location.

**16.** A device as claimed in claim 11, 12, 13, 14 or 15, characterised in that the reactance element is a capacitor (62).

**17.** A device as claimed in claim 16, characterised in that the portions (11b, 11d) of the antenna element (11B) have inward projections (71b, 72b) overlapping across the slot to form the capacitor (62).

**18.** A device as claimed in any of claims 11 to 17, characterised in that the antenna elements (11A, 11B) are perforated by holes (77), the number of which increases towards the connecting point of the reactance element (62).

**19.** A device as claimed in any of claims 11 to 18, characterised in that the thickness of the wrist straps (2a, 2b) increases towards the connecting point of the reactance element (62) on the side of the antenna elements towards the wearer in use.

**20.** A device as claimed in claim 19, characterised in that the increased thickness is provided by raised portions (91a) or projections (92a) of the strap.

**21.** A device as claimed in claim 10, or any claim appendant to claim 10, characterised in that the slot-divided portions (11a, 11c; 11b, 11d) of each antenna element (11A, 11B) are connected at their ends remote from the main body (1a) by means for reducing the resistivity to high frequency current.

**22.** A device as claimed in claim 21, characterised in that the portion (11p) connecting the slot-divided portions (11a, 11c; 11b, 11d) is coated with a layer (89) of high electrical conductivity metal.

**23.** A device as claimed in any preceding claim, characterised in that the slot antenna has a high dielectric material layer coated on one or other side thereof.

**Patentansprüche**

**1.** Elektronische Vorrichtung, die am Handgelenk montierbar ist und versehen ist mit einem Hauptkörper (1a) mit einer Vorderfläche, die vom Träger im Gebrauch abgewandt ist, und einer hinteren Fläche, die dem Träger im Gebrauch zugewandt ist, einer darin befindlichen Schaltungsplatine (5), sowie einer Antennenvorrichtung, die eine Schlitzantenne (13; 39) umfaßt, die mit der Schaltungsplatine verbunden ist, wobei die Schlitzantenne Antennenelemente (11A, 11B) umfaßt, die in Handgelenkriemen (2a, 2b) angeordnet sind, die am Hauptkörper (1a) angebracht sind, und wobei elektrisch leitende Elemente (4a, 4b) die Antennenelemente (11A, 11B) verbinden und innerhalb des Hauptkörpers (1a) angeordnet sind, wobei die elektrisch leitenden Elemente (4a, 4b) von der Seite der Schaltungsplatine (5), die der Vorderfläche des Hauptkörpers (1a) näher ist, beabstandet sind; dadurch gekennzeichnet, daß der Hauptkörper (1a) eine reflektierende Platte (6) enthält, um den Antennengewinneffekt zu steigern, wobei die reflektierende Platte (6) im Hauptkörper (1a) auf der Seite der Schaltungsplatine (5) angeordnet ist, die näher an der hinteren Fläche des Hauptkörpers (1a) liegt.

**2.** Vorrichtung nach Anspruch 1, dadurch gekennzeichnet, daß der Hauptkörper (1a) eine Anzeigeeinheit (3) nahe der vorderen Fläche des Hauptkörpers (1a) und durch diese sichtbar besitzt, wobei die Antennenelementverbindungselemente (4a, 4b) längs den Außenkanten der Anzeigeeinheit (3) angeordnet sind.

**3.** Vorrichtung nach Anspruch 2, dadurch gekennzeichnet, daß die Antennenelementverbindungselemente (4a, 4b) näher an der Vorderfläche des Hauptkörpers (1a) angeordnet sind als die Anzeigeeinheit (3) und im wesentlichen eine transparente Dünnschicht umfassen.

4. Vorrichtung nach Anspruch 1, dadurch gekennzeichnet, daß die Antenne (39) um einen äußeren Rahmen (38a) des Hauptkörpers (1a) angeordnet ist, wobei ihre Schlitze (39c) sich am Umfang des äußeren Rahmens (36a) erstrecken.

5. Vorrichtung nach irgendeinem der vorangehenden Ansprüche, dadurch gekennzeichnet, daß die Antennenelementverbindungselemente (4a, 4b) durch den Antennenschlitz getrennt sind, wobei ein Element mit einer Referenzspannungsseite eines Hochsequenz-Wellenverstärkers auf der Schaltungsplatine (5) verbunden ist, während das andere Element mit einer Signalspannungsseite des Verstärkers verbunden ist, wobei das andere Element weiter von den Störquellen in den Schaltungen auf der Schaltungsplatine (5) entfernt ist als das eine Element.

6. Vorrichtung nach Anspruch 5, dadurch gekennzeichnet, daß das eine Element über ein Reaktanzelement mit der Referenzspannungsseite verbunden ist.

7. Vorrichtung nach Anspruch 5 oder 6, dadurch gekennzeichnet, daß die Schaltungen auf der Schaltungsplatine (5) einen lokalen Oszillator auf der hinteren Flächenseite der Schaltungsplatine (5) enthalten.

8. Vorrichtung nach Anspruch 7, dadurch gekennzeichnet, daß der lokale Oszillator von mehreren Teilen mit demselben Spannungspegel umgeben ist.

9. Vorrichtung nach einem der Ansprüche 5, 6, 7 oder 8, dadurch gekennzeichnet, daß das eine Element elektrisch mit einer Stromquelle verbunden ist zum Ansteuern der Schaltungen auf der Schaltungsplatine (5).

10. Vorrichtung nach einem der Ansprüche 5, 6, 7, 8 oder 9, dadurch gekennzeichnet, daß das eine Element elektrisch mit einem Abschirmungselement verbunden ist, mit dem die Störquellen abgedeckt sind.

11. Vorrichtung nach irgendeinem der vorangehenden Ansprüche, gekennzeichnet durch ein Reaktanzelement (62), das die Abschnitte der Antenne quer zum Schlitz an deren zentralem Longitudinalpunkt verbindet.

12. Vorrichtung nach Anspruch 11, dadurch gekennzeichnet, daß die Antennenelemente (11A, 11B) unterschiedliche Längen aufweisen, wobei der Verbindungspunkt der Antenne innerhalb des Hauptkörpers (1a) liegt und gegenüber der Reaktanzelement-Verbindungsposition versetzt ist.

13. Vorrichtung nach Anspruch 12, dadurch gekennzeichnet, daß das kürzere Element (11A) im Handgelenkriemen (2a) mit einer Stifttyp-Schnalle (67, 68) zum Verbinden der Handgelenkriemen angeordnet ist, wobei das längere Element (11B) im Handgelenkriemen (2b) mit wenigstens einem Loch (69) zum Aufnehmen des Stifts (68) der Schnalle (67) angeordnet ist.

14. Vorrichtung nach Anspruch 13, dadurch gekennzeichnet, daß das Loch oder die Löcher (69) in Querrichtung im Zentrum des Schlitzes angeordnet sind.

15. Vorrichtung nach Anspruch 14, dadurch gekennzeichnet, daß der Schlitz einen erweiterten Abschnitt (71) beim jeweiligen Ort des Stiftaufnahmelochs besitzt.

16. Vorrichtung nach einem der Ansprüche 11, 12, 13, 14 oder 15, dadurch gekennzeichnet, daß das Reaktanzelement ein Kondensator (62) ist.

17. Vorrichtung nach Anspruch 16, dadurch gekennzeichnet, daß die Abschnitte (11b, 11d) des Antennenelements (11b) nach innen gerichtete Vorsprünge (71b, 72b) besitzen, die sich quer zum Schlitz überlappen, um den Kondensator (62) zu bilden.

18. Vorrichtung nach irgendeinem der Ansprüche 11 bis 17, dadurch gekennzeichnet, daß die Antennenelemente (11A, 11B) mittels Löchern (77) perforiert sind, wobei die Anzahl der Löcher in Richtung zum Verbindungspunkt des Reaktanzelements (62) zunimmt.

19. Vorrichtung nach irgendeinem der Ansprüche 11 bis 18, dadurch gekennzeichnet, daß die Dicke der Handgelenkriemen (2a, 2b) in Richtung zum Verbindungspunkt des Reaktanzelements (62) auf der Seite der Antennenelemente in Richtung zum Träger im Gebrauch zunimmt.

20. Vorrichtung nach Anspruch 19, dadurch gekennzeichnet, daß die erhöhte Dicke durch erhabene Abschnitte (91a) oder Vorsprünge (92a) des Riemens geschaffen wird.

21. Vorrichtung nach Anspruch 10 oder irgendeinem von Anspruch 10 abhängigen Anspruch, dadurch gekennzeichnet, daß die durch den Schlitz unterteilten Abschnitte (11a, 11c; 11b, 11d) jedes Antennenelements (11A, 11B) an ihren Enden entfernt vom Hauptkörper (1a) durch eine Einrichtung zum Reduzieren der Resistivität für einen Hochfrequenzstrom verbunden sind.

**22.** Vorrichtung nach Anspruch 21, dadurch gekennzeichnet, daß der Abschnitt (11p), der die durch den Schlitz unterteilten Abschnitte (11a, 11c; 11b, 11d) verbindet, mit einer Schicht (29) eines Metalls mit hoher elektrischer Leitfähigkeit beschichtet ist.

**23.** Vorrichtung nach irgendeinem der vorangehenden Ansprüche, dadurch gekennzeichnet, daß die Schlitzantenne an der einen oder an der anderen Seite mit einer Materialschicht mit hoher Dielektrizität beschichtet ist.

**Revendications**

**1.** Dispositif électronique montable sur un poignet, comprenant un corps principal (1a) ayant une surface avant tournée à l'opposé d'un porteur pendant l'utilisation et une surface arrière tournée vers le porteur pendant l'utilisation, une carte de circuits (5) à l'intérieur et un dispositif d'antenne comprenant une antenne à fente (13; 39) connectée à la carte de circuits, l'antenne à fente comportant des éléments d'antenne (11A, 11B) situés dans des bracelets de poignet (2a, 2b) qui sont fixés au corps principal (1a), et des éléments électriquement conducteurs (4a, 4b) connectant les éléments d'antenne (11A, 11B) et situés à l'intérieur du corps principal (1a), dans lequel les éléments électriquement conducteurs (4a, 4b) sont séparés et se trouvent sur le côté de la carte de circuits (5) plus proche de la surface avant du corps principal (1a) ; caractérisé en ce que le corps principal (1a) contient une plaque réfléchissante (6) pour renforcer l'effet de gain de l'antenne, la plaque réfléchissante (6) étant située dans le corps principal (1a) du côté de la carte de circuits (5) qui est plus proche de la surface arrière du corps principal (1a).

**2.** Dispositif selon la revendication 1, caractérisé en ce que le corps principal (1a) comporte une unité d'affichage (3) adjacente à et visible depuis la surface avant du corps principal (1a) et en ce que les éléments de connexion (4a, 4b) pour les éléments d'antenne sont disposés le long des bords extérieurs de l'unité d'affichage (3).

**3.** Dispositif selon la revendication 2, caractérisé en ce que les éléments de connexion (4a, 4b) pour les éléments d'antenne sont situés plus près de la surface avant du corps principal (1a) que l'unité d'affichage (3) et sont faits d'un film mince sensiblement transparent.

**4.** Dispositif selon la revendication 1, caractérisé en ce que l'antenne (39) est située autour d'un cadre externe (38a) du corps principal (1a), sa fente (39c) s'étendant de manière périphérique par rapport au cadre externe (36a).

**5.** Dispositif selon l'une quelconque des revendications précédentes, caractérisé en ce que les éléments de connexion (4a, 4b) pour les éléments d'antenne sont séparés de la fente d'antenne, l'un des éléments étant connecté à un côté de la tension de référence d'un amplificateur d'ondes de haute fréquence sur la carte de circuits (5), tandis que l'autre élément est connecté au côté de la tension de signal de l'amplificateur, ledit autre élément étant plus éloigné des sources de bruit dans les circuits situés sur la carte de circuits (5) que le premier élément.

**6.** Dispositif selon la revendication 5, caractérisé en ce que le premier élément est connecté au côté de la tension de référence par l'intermédiaire d'un élément à réactance.

**7.** Dispositif selon la revendication 5 ou 6, caractérisé en ce que les circuits situés sur la carte de circuits (5) comportent un oscillateur local du côté de la surface arrière de la carte de circuits (5).

**8.** Dispositif selon la revendication 7, caractérisé en ce que l'oscillateur local est entouré par une pluralité de parties au même niveau de tension.

**9.** Dispositif selon la revendication 5, 6, 7 ou 8, caractérisé en ce que le premier élément est électriquement connecté à une source d'alimentation pour piloter les circuits situés sur la carte de circuits (5).

**10.** Dispositif selon la revendication 5, 6, 7, 8 ou 9, caractérisé en ce que le premier élément est électriquement connecté à un élément de blindage par lequel les sources de bruit sont recouvertes.

**11.** Dispositif selon l'une quelconque des revendications précédentes, caractérisé par un élément à réactance (62) connectant les portions de l'antenne à travers la fente au niveau de son point longitudinal central.

**12.** Dispositif selon la revendication 11, caractérisé en ce que les éléments d'antenne (11A, 11B) ont des longueurs différentes, le point de connexion de l'antenne étant situé à l'intérieur du corps principal (1a) et décalé par rapport à la position de connexion de l'élément à réactance.

**13.** Dispositif selon la revendication 12, caractérisé en ce que l'élément le plus court (11A) est situé dans le bracelet (2a) comportant une boucle du type à ardillon (67, 68) pour relier ensemble les bracelets et l'élément le plus long (11B) est situé dans le bracelet (2b) avec au moins un trou (69) pour recevoir l'ardillon (68) de la boucle (67).

**14.** Dispositif selon la revendication 13, caractérisé en ce que le trou ou les trous (69) est ou sont situés au centre de la fente dans le sens transversal.

**15.** Dispositif selon la revendication 14, caractérisé en ce que la fente comporte une portion élargie (71) à l'emplacement du ou de chaque trou de réception d'ardillon.

**16.** Dispositif selon la revendication 11, 12, 13, 14 ou 15, caractérisé en ce que l'élément à réactance est un condensateur (62).

**17.** Dispositif selon la revendication 16, caractérisé en ce que les portions (11b, 11d) de l'élément d'antenne (11B) comportent des saillies vers l'intérieur (71b, 72b) qui se recouvrent à travers la fente pour former le condensateur (62).

**18.** Dispositif selon l'une quelconque des revendications 11 à 17, caractérisé en ce que les éléments d'antenne (11A, 11B) sont perforés par des trous (77) dont le nombre augmente vers le point de connexion de l'élément à réactance (62).

**19.** Dispositif selon l'une quelconque des revendications 11 à 18, caractérisé en ce que l'épaisseur des bracelets (2a, 2b) augmente vers le point de connexion de l'élément à réactance (62) du côté des éléments de l'antenne vers le porteur pendant l'utilisation.

**20.** Dispositif selon la revendication 19, caractérisé en ce que l'épaisseur accrue est réalisée par des portions surélevées (91a) ou saillie (92a) du bracelet.

**21.** Dispositif selon la revendication 10 ou l'une quelconque des revendications dépendant de la revendication 10, caractérisé en ce que les portions divisées en fente (11a, 11c; 11b, 11d) de chaque élément d'antenne (11A, 11B) sont connectées à leurs extrémités distantes du corps principal (1a) par des moyens pour réduire la résistivité à un courant de haute fréquence.

**22.** Dispositif selon la revendication 21, caractérisé en ce que la portion (11p) connectant les portions divisées en fente (11a, 11c; 11b, 11d) est revêtue d'une couche (89) de métal à haute conductivité électrique.

**23.** Dispositif selon l'une quelconque des revendications précédentes, caractérisé en ce que l'antenne à fente comporte une couche de matériau hautement diélectrique déposée sur l'un ou l'autre côté de celle-ci.

F I G.   1 (a)

F I G. 1 (b)

<u>13</u>

FIG. 2

FIG. 3

FIG. 4 (a)

FIG. 4 (b)

F I G. 5

F I G. 6 (a)

**13** ANTENNA ASSEMBLY

201 202 203 204 205 206

RF → ⊗ → I F → DET → [ ] → CPU →

VCO ← LPF ← PHASE COMP. ― 209

208 211 210

207

200 PLL

F I G. 6 (b)

**13** ANTENNA ASSEMBLY

Mixter

301 302 303 304 305 306

RF → ⊗ → LPF → DET → [ ] → CPU →

― 307

F I G. 7

F I G. 8

F I G.  9

F I G.  1 0

F I G. 1 1 (a)

F I G. 11 (b)

F I G. 1 2

FIG. 13

F I G. · 1 4 (a)

(a)

F I G. 14 (b)

FIG. 15

FIG. 16

F I G.  1 7

FIG. 18

FIG. 19

FIG. 20

FIG. 21

35

F I G. 2 2 (a)

F I G. 22 (b)

F I G.　2 3

F I G.　2 4

FIG. 25

F I G. 2 6

FIG. 27

FIG. 28 (a)

FIG. 28 (b)

F I G. 2 9

F I G. 3 0

FIG. 31

FIG. 32

FIG. 33

FIG. 34

FIG. 35

FIG. 36

F I G. 3 7

F I G. 3 8

FIG. 39

FIG. 40

F I G. 4 1

F I G.   4 2

95

4a,4b
98   5
1a   5f   3   98
13c   99   96c   96c   99
11c.11d
13   96a   96b   97   96a   11a,11b
96b
8